# EUROPÄISCHE PATENTANMELDUNG

(11) **EP 2 700 455 A1**
(43) Veröffentlichungstag der Anmeldung: **26.02.2014**
(21) Anmeldenummer: 12181454.5
(22) Anmeldetag: 23.08.2012
(51) Int. Cl.: B05D 3/14, B05D 3/04, B05D 1/02

(54) **Nasslackapplikation auf Kunststoffsubstraten mit Plasmahärtung**

(71) Anmelder: Bayer MaterialScience AG, 51373 Leverkusen (DE)
(72) Erfinder: Kuhlmann, Timo, 42799 Leichlingen (DE); Noreiks, Uwe, 47495 Rheinberg (DE); Oser, Rafael, Dr., 47800 Krefeld (DE)
(74) Vertreter: BIP Patents

(57) **Zusammenfassung**

Die Erfindung betrifft ein Verfahren zur Beschichtung eines Kunststoffsubstrats mit Funktionsschichten, in dem man mindestens eine Oberfläche des Kunststoffsubstrats mit einer Funktionsschicht in Form eines Nasslacks beschichtet, die Nasslackbeschichtung in einer Vakuumkammer erfolgt und der Nasslack durch Einwirkung eines Plasmas in der Vakuumkammer bei Niederdruckbedingungen härtet; alternativ kann vor Auftrag der Nasslackschicht eine erste Funktionsschicht mittels plasmagestützter Gasphasenabscheidung auf eine Oberfläche des Kunststoffsubstrats aufgetragen werden.

## Beschreibung

Die Erfindung betrifft ein Verfahren zur Beschichtung eines Kunststoffsubstrats mit Funktionsschichten durch Auftragen eines Nasslacks und gegebenenfalls durch plasmainduzierte Gasphasenabscheidung sowie eine Vorrichtung zur Durchführung des Verfahrens. Ferner betrifft die Erfindung ein mittels des Verfahrens hergestelltes Kunststoffsubstrat und dessen Verwendung.

### HINTERGRUND DER ERFINDUNG

Zur Herstellung von Gehäusen für Elektrogeräte, Fensterprofilen, Scheinwerferstreuscheiben, Karosserieelementen, Maschinenabdeckungen, Autoscheiben und Architekturverscheibungen werden zunehmend Kunststoffformteile eingesetzt. Kunststoffformteile können mit geringem Fertigungsaufwand extrudiert oder durch Spritzguss erzeugt werden. Darüber hinaus können aus Kunststoff komplexe Formen mit großer Designfreiheit hergestellt werden.

Um Kunststoffformteile vielfältig einsetzen zu können, ist es erforderlich, die relativ weichen und chemisch nicht sehr widerstandsfähigen Kunststoffoberflächen zu vergüten, um sie beispielsweise kratz- und verschleißfest zu machen und gegen Witterungseinflüsse, insbesondere UV-Licht, zu schützen. Zu diesem Zweck werden ein- oder zweischichtige Kratzfestlacksysteme auf der Basis von siliciumorganischen Verbindungen verwendet, die durch Flut- oder Spritzlackierung auf das zu schützende Substrat aufgebracht werden können.

Zur Verbesserung des Haftvermögens von Funktionsschichten auf einer Kunststoffsubstrat-Oberfläche können Primer eingesetzt werden. Primer sind Grundbeschichtungen mit beispielsweise haftvermittelnder, passivierender und/oder korrosionshemmender Wirkung. Solche Primer sind in der US 6 350 512 B1, der US 5 869 185 B1, der EP 1 308 084 A1 und der WO 2006/108520 A1 beschrieben.

Sogenannte Kratzfestlacke (Hard-Coat) enthalten im Allgemeinen einen hohen Anteil an Siloxanen. Sie können durch Tauch- oder Fließverfahren auf Kunststoffformteile aufgebracht werden. Derartige Systeme sind in der US 5 041 313 A, der DE 31 21 385 A1, der US 5 391 795 A und der WO 2008/109072 A1 beschrieben.

Anstelle der Primer/Kratzfestbeschichtungs-Kombinationen können Einkomponenten-Hybrid-Systeme eingesetzt werden. Diese sind beispielsweise in EP 0 570 165 B1 oder der WO 2008/071363 A2 oder der DE 28 04 283 A2 beschrieben.

Es wurden verschiedene Versuche beschrieben, UV-Schutz und Kratz-Schutz miteinander zu kombinieren. Die US 5 156 882 beschreibt UV-Licht absorbierende, abriebfeste Beschichtungen und Verfahren zu ihrer Herstellung, wobei die Beschichtung mittels plasmaunterstützter Gasphasenabscheidung erzeugt wird, wobei als UV-Absorber anorganische Oxide eingebaut werden. Die Beschichtung beinhaltet Multilagenstrukturen, wobei die Einzelschichten hinsichtlich Schichtdicke und Brechungsindex über die ganze Fläche sehr präzise abgeschieden werden müssen.

Einen anderen Weg beschreibt die WO 2007/0026235 A1, in der eine Lackschicht mit organischen UV-Absorbern, mit siliciumorganischen Monomeren, die in einem Plasmapolymerisationsprozess abgeschieden werden, beschichtet werden. Dieses Verfahren ist sehr aufwendig. Es müssen sowohl eine komplette Nasslackierung als auch eine nachträgliche Plasmapolymerisation in einer Vakuumkammer erfolgen.

In der WO 03/089479 A2 wird ein mit UV-Schutz versehener UV-härtbarer Lack auf ein Formteil aufgebracht und anschließend in einer Vakuumkammer mit der UV-Strahlung einer Plasmaquelle ausgehärtet.

### ZUSAMMENFASSUNG DER ERFINDUNG

Der Erfindung liegt die Aufgabe zugrunde, ein gegenüber dem Stand der Technik vereinfachtes Verfahren zur Beschichtung von Kunststoffsubstraten mit Funktionsschichten, insbesondere UV-Absorber- und Kratzfestschichten, bereitzustellen.

Gelöst wird diese Aufgabe durch ein Verfahren zur Beschichtung eines Kunststoffsubstrats mit Funktionsschichten, in dem man
(a) mindestens eine Oberfläche des Kunststoffsubstrats mit einer Funktionsschicht in Form eines Nasslacks in einer Vakuumkammer beschichtet und
(b) den Nasslack durch Einwirkung eines Plasmas in der Vakuumkammer härtet.

Gegenstand der Erfindung ist ferner ein Verfahren zur Beschichtung eines Kunststoffsubstrats mit Funktionsschichten, in dem man
(a) in einer Vakuumkammer bei Niederdruckbedingungen mittels plasmainduzierter Gasphasenabscheidung auf mindestens eine Oberfläche des Kunststoffsubstrats eine erste Funktionsschicht aufbringt,
(b) die beschichtete Oberfläche des Kunststoffsubstrats in der Kammer mit einer zweiten Funktionsschicht in Form eines Nasslacks beschichtet und
(c) den Nasslack durch Einwirkung eines Plasmas in der Vakuumkammer härtet.

Ferner ist Gegenstand der Erfindung ein mit UV-Schutzschicht und Kratzschutzschicht beschichtetes Kunststoffformteil, das durch ein erfindungsgemäßes Verfahren erhalten wurde.

Gegenstand der Erfindung ist schließlich eine Vorrichtung zur Beschichtung eines Kunststoffsubstrats mit Funktionsschichten, umfassend mindestens eine Vakuumkammer, mindestens eine Sprühvorrichtung und mindestens eine Plasmaquelle, wobei die Sprühvorrichtung und die Plasmaquelle innerhalb der Vakuumkammer angeordnet sind.

### BESCHREIBUNG DER BEVORZUGTEN AUSFÜHRUNGSFORMEN

Eine Funktionsschicht im Sinne der Erfindung ist eine Schicht, die derart ausgebildet oder zusammengesetzt ist, dass sie dem beschichteten Substrat mindestens eine gewünschte Eigenschaft verleiht. Solchen Eigenschaften können ein verbesserter Schutz gegenüber UV-Licht, IR-Strahlung, höhere Kratzfestigkeit, Härte oder Elastizität sein. Funktionsschichten im Sinne der Erfindung können folglich Schichten mit einem UV-Absorber und Kratzfestschichten umfassen.

Gegenüber bekannten Verfahren erlauben die erfindungsgemäßen Beschichtungsverfahren eine deutliche Verkürzung der zur Beschichtung des Substrats erforderlichen Zeit. Weil Lackierung und Plasmahärtung in derselben Behandlungseinrichtung erfolgen, können die sonst zwischen Lackierung und Plasmahärtung nötigen Transportschritte eingespart werden.

Die erfindungsgemäßen Verfahren ermöglichen ferner in einfacher Weise die Kombination einer Nasslackierung mit einer Beschichtung durch plasmagestützte Gasphasenabscheidung. Eine plasmagestützte Gasphasenabscheidung kann sowohl vor einer Nasslackierung oder nach einer Nasslackierung auf das Kunststoffsubstrat aufgebracht werden.

Die Kratzfestigkeit einer beschichteten Probe kann vorzugsweise mit dem Taber Abrasion Test nach DIN 52347 unter Nutzung von CS10F-Rädern der vierten Generation mit 500g Auflagegewicht pro Rad mit angeschlossener Messung der Streulichtzunahme nach ASTM D 1003 unter Verwendung eines Haze Gard Plus der Firma Byk-Gardner ermittelt werden. Die Berechnung des Differenzwertes der Trübung in Prozent (%) vor und nach der Belastung durch die Reibräder gibt Aufschluss über die Güte der Kratzfestigkeit. Beschichtungsschichten, die nach dem erfindungsmäßen Verfahren hergestellt worden sind, weisen nach einer Belastung von 500 Umdrehungen bevorzugt eine Differenz der Trübungswerte von kleiner 20 %, besonders bevorzugt eine Differenz kleiner 10 % und ganz besonders bevorzugt eine Differenz kleiner 5 % auf.

### Lack

Ein für die erfindungsgemäßen Verfahren geeigneter Nasslack ist eine fließfähige oder streichfähige Zusammensetzung mit Substanzen, die dem Lack die gewünschten Eigenschaften verleihen. Ein im erfindungsgemäßen Verfahren verwendeter Nasslack enthält vorzugsweise mindestens einen Bestandteil aus unter Einwirkung von Strahlung härtendem Bindemittel (Komponente A), Reaktivverdünner (Komponente B) und Isocyanatgruppen-haltigen Acrylaten (Komponente C) sowie mindestens einen Fotoinitiator (Komponente E). Darüber hinaus enthält der erfindungsgemäße Lack gegebenenfalls mindestens einen UV-Absorber (Komponente D) und/oder gegebenenfalls die mechanische Festigkeit sowie die Fließfähigkeit der Lacklösung verbessernde Mittel (Komponente F).

Die erfindungsgemäße Nasslackschicht mit UV-Absorber ist vorzugsweise eine klare, farblose und transparente Schicht. Darüber hinaus kann die erfindungsgemäß erzeugte Nasslackschicht derart ausgebildet sein, dass sie Kratzfestigkeit verleiht.

Eine erfindungsgemäß "farblose" Schicht weist einen niedrigen Yellowness-Index auf. Der Yellowness-Index ist ein Wert für die Vergilbung eines an sich farblosen Materials und kann beispielsweise gemäß ASTM D 313 mit einem Spektralphotometer Perkin Elmer Lambda 900 ermittelt werden.

Eine erfindungsgemäß "transparente" Schicht weist einen hohen Grad an Lichttransmission nachfolgend Transmission genannt auf. Die Transmission bzw. Extinktion kann beispielsweise mit einem Spektralphotometer Perkin Elmer Lambda 900 in einem spektralen Bereich von 200 nm bis 700 nm von 0° / diffus nach ISO 13468-1 ermittelt werden.

Eine erfindungsgemäße Lackschicht, die einen UV-Absorber enthält, weist eine hohe UV-Absorption auf. Ein Messwert für die UV-Absorption ist die optische Dichte bei 340 nm nachfolgend als OD340 bezeichnet. Diese kann beispielsweise auch mit einem Spektralphotometer Perkin Elmer Lambda 900 ermittelt werden. Vorzugsweise liegt die OD340 bei mindestens 0,4. Besonders bevorzugt liegt die OD340 bei mindestens 1,0 und insbesondere liegt die OD340 bei mindestens 2,0.

### Komponente A: Unter Strahlung härtende Bindemittel

Als unter Strahlung härtende Bindemittel kommen eine oder mehrere monomere oder polymere Verbindungen in Frage, die mindestens zwei funktionelle Gruppen tragen, die durch Einwirkung aktinischer Strahlung mit ethylenisch ungesättigten Verbindungen unter Polymerisation reagieren und die keine Isocyanat-Gruppen aufweisen.

Solche Verbindungen sind beispielsweise Ester, Carbonate, Acrylate, Ether, Urethane oder Amide oder polymere Verbindungen dieser Strukturtypen. Es können auch beliebige Mischungen solcher Monomere und/oder Polymere eingesetzt werden, die mindestens zwei unter Einwirkung aktinischer Strahlung polymerisierbare Gruppen enthalten.

Als Verbindungen der Komponente A können modifizierte Monomere oder Polymere eingesetzt werden, deren Modifizierung nach an sich bekannten Methoden erfolgt. Bei der Modifizierung werden entsprechende chemische Funktionalitäten in die Moleküle eingefügt. Geeignet sind α,β-ungesättigte Carbonsäurederivate wie Acrylate, Methacrylate, Maleinate, Fumarate, Maleimide, Acrylamide, weiterhin Vinylether, Propenylether, Allylether und Dicyclopentadienyl-Einheiten enthaltende Verbindungen. Bevorzugt sind Vinylether, Acrylate und Methacrylate, besonders bevorzugt sind Acrylate.

Geeignete Beispiele solcher Verbindungen umfassen die in der Technologie der Strahlenhärtung bekannten Bindemittel wie Polyetheracrylate, Polyesteracrylate, Urethanacrylate, Epoxyacrylate, Melaminacrylate, Silikonacrylate, Polycarbonatacrylate und acrylierte Polyacrylate.

Geeignete Ester werden üblicherweise durch Veresterung von Alkoholen mit 2 bis 20 Kohlenstoffatomen, bevorzugt mehrwertigen Alkoholen mit 2 bis 20 Kohlenstoffatomen, mit ungesättigten Säuren oder ungesättigten Säurechloriden erhalten, bevorzugt Acrylsäure und deren Derivate. Dazu können die dem Fachmann bekannten Methoden der Veresterung angewendet werden.

Geeignete Alkoholkomponenten bei der Veresterung sind einwertige Alkohole wie die isomeren Butanole, Pentanole, Hexanole, Heptanole, Octanole, Nonanole und Decanole, weiterhin cycloaliphatische Alkohole wie Isobornol, Cyclohexanol und alkylierte Cyclohexanole, Dicyclopentanol, arylaliphatische Alkohole wie Phenoxyethanol und Nonylphenylethanol sowie Tetrahydrofurfurylalkohole. Ebenfalls geeignet sind zweiwertige Alkohole wie Ethylenglykol, Propandiol-1,2, Propandiol-1,3, Diethylenglykol, Dipropylenglykol, die isomeren Butandiole, Neopentylglykol, Hexandiol-1,6, 2-Ethylhexandiol, 1,4-Cyclohexandiol, 1,4-Cyclohexandimethanol und Tripropylenglykol. Geeignete höherwertige Alkohole sind Glycerin, Trimethylolpropan, Ditrimethylolpropan, Pentaerythrit oder Dipentaerythrit. Bevorzugt sind Diole und höherwertige Alkohole, besonders bevorzugt sind Glycerin, Trimethylolpropan, Pentaerythrit, Dipentaerythrit und 1,4-Cyclohexandimethanol.

Geeignete Ester bzw. Urethane sind beispielsweise auch durch Umsetzung ungesättigter OH-funktioneller, ungesättigter Verbindungen mit 2 bis 12, vorzugsweise 2 bis 4 Kohlenstoffatomen, sowie wahlweise vorgenannte Alkoholkomponenten mit Säuren, Estern, Säureanhydriden oder Säurechloriden bzw. Isocyanaten zugänglich.

Als hydroxyfunktionelle Acrylate oder Methacrylate kommen beispielsweise Verbindungen wie 2-Hydroxyethyl(meth)acrylat, Polyethylenoxid-mono(meth)acrylate, Polypropylenoxid-mono-(meth)acrylate, Polyalkylenoxidmono(meth)acrylate, Poly(s-caprolacton)-mono-(meth)acrylate, wie z.B. **Tone**^{®} M100 (Dow, Schwalbach, DE), 2-Hydroxypropyl(meth)acrylat, 4-Hydroxybutyl(meth)acrylat, 3-Hydroxy-2,2-dimethylpropyl(meth)-acrylat, die hydroxy-funktionellen Mono-, Di- oder Tetraacrylate mehrwertiger Alkohole wie Trimethylolpropan, Glycerin, Pentaerythrit, Dipentaerythrit, ethoxiliertes, propoxiliertes oder alkoxyliertes Trimethylolpropan, Glycerin, Pentaerythrit, Dipentaerythrit oder deren technische Gemische in Betracht.

Beispiele für bevorzugte ungesättigte OH-funktionelle Verbindungen sind Hydroxyethyl-(meth)acrylat, 2- und 3-Hydroxypropyl(meth)acrylat, 2-, 3- und 4-Hydroxy-butyl-(meth)-acrylat, weiterhin OH funktionelle Vinylether, wie Hydroxybutylvinylether sowie deren Mischungen.

Des Weiteren können als OH-funktionelle ungesättigte Verbindungen OH-funktionelle (Meth)acrylsäureester bzw. -amide eingesetzt werden, die durch Umsetzung von bis zu n-1 Äquivalenten (Meth)acrylsäure mit n-wertigen Alkoholen, Aminen, Aminoalkoholen und/oder deren Gemischen erhältlich sind. Als n-wertige Alkohole kommen dabei Glycerin, Trimethylolpropan und/oder Pentaerythrit in Frage.

Ebenfalls können Produkte aus der Umsetzung von epoxyfunktionellen (Meth)acrylsäurestern mit (Meth)Acrylsäure verwendet werden. So ergibt die Umsetzung von Glycidylmethacrylat mit Acrylsäure einen gemischten Acrylsäure-Methacrylsäureester des Glycerins, der besonders vorteilhaft verwendet werden kann.

Zur Darstellung von Urethanen aus diesen OH-funktionellen ungesättigten Verbindungen können Mono-, Di- oder Polyisocyanate verwendet werden. Dazu eignen sich isomere Butylisocyanate, Butylendiisocyanat, Hexamethylendiisocyanat (HDI), Isophorondiisocyanat (IPDI), 2,2,4- und/oder 2,4,4-Trimethylhexamethylendiisocyanat, die isomeren Bis(4,4'-isocyanatocyclohexyl)methane oder deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat, Triphenylmethan-4,4',4"-triisocyanat oder deren Derivate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur und Mischungen derselben.

Bevorzugt sind Polyisocyanate auf Basis oligomerisierter und/oder derivatisierter Diisocyanate, die durch geeignete Verfahren von überschüssigem Diisocyanat befreit wurden, insbesondere die des Hexamethylendiisocyanat, Isophorondiisocyanat und der isomeren Bis(4,4'-isocyanatocyclohexyl)methane sowie deren Mischungen. Bevorzugt sind die oligomeren Isocyanurate, Uretdione, Allophanate und Iminooxadiazindione des HDI, die oligomeren Isocyanurate, Uretdione und Allophanate des IPDI sowie die oligomeren Isocyanurate der isomeren Bis(4,4'-isocyanatocyclohexyl)methane sowie deren Mischungen.

Analog der obigen Beschreibung sind geeignete Polyester, Polycarbonate oder Polyurethane beispielsweise durch Umsetzung ungesättigter OH-funktioneller Verbindungen mit 2 bis 12 Kohlenstoffatomen, vorzugsweise 2 bis 4 Kohlenstoffatomen mit beispielsweise Säure-, Ester- oder Säurechloridfunktionellen Polyestern oder Polycarbonaten oder NCO-funktionellen Polyurethanen zugänglich.

Geeignet sind auch Umsetzungsprodukte von Polyestern mit Säurezahlen größer als 5 und glycidylfunktionellen (Meth-)acrylaten (z.B. Glycidylmethacrylat).

Bevorzugt als OH-funktionelle ungesättigte Verbindungen zum Aufbau ungesättigter Polyester, Polycarbonate und Polyurethane sind Hydroxyethylacrylat und die isomeren Hydroxypropylacrylate. Besonders bevorzugt ist das Umsetzungsprodukt aus Glycidylmethacrylat und Acrylsäure.

Polyacrylate können nur nach der Polymerisation der Acrylat- und Vinylaromatenmonomere strahlenhärtend modifiziert werden. Dies gelingt über funktionelle Gruppen, die inert gegenüber den Herstellungsbedingungen des Polyacrylats sind und anschließend erst zu ungesättigten strahlenhärtenden Gruppen weiter modifiziert werden.

Für diesen Zweck geeignete Gruppen sind beispielsweise die in der folgenden Tabelle aufgeführten:

| Inerte Gruppe | Modifizierungsreagenz | Strahlenhärtende Gruppe |
|---|---|---|
| Epoxy | Acrylsäure, dimere Acrylsäure | Acrylat |
| Säure | Glycidylmethacrylat | Methacrylat |
| Säure | Hydroxyalkylacrylat | Acrylat |
| Alkohol | Maleinsäureanhydrid | Maleinat |
| Alkohol | Acrylsäure, dimere Acrylsäure | Acrylat |
| Alkohol | Acrylfunktionelles Isocyanat | Urethanacrylat |
| Isocyanat | Hydroxyalkylacrylat | Urethanacrylat |
| Anhydrid | Hydroxyalkylacrylat | Acrylat |

Von den Polyacrylaten sind die Diacrylate wie Hexandioldiacrylat bevorzugt.

Aus den obengenannten Verbindungen sind die Ausgangsverbindungen zur Herstellung der Verbindungen der Komponente A jeweils so zu wählen, dass die resultierenden Verbindungen eine Molmasse größer 450 g/mol besitzen und jeweils mindestens zwei funktionelle Gruppen tragen, die durch Einwirkung aktinischer Strahlung mit ethylenisch ungesättigten Verbindungen unter Polymerisation reagieren und keine Isocyanat-Gruppen aufweisen.

Bevorzugt werden Urethanacrylate hergestellt aus vorgenannten Hydroxyalkylacrylaten, Diolen bzw. Polyolen und aliphatischen Diisocyanaten bzw. Polyisocyanaten eingesetzt, die mindestens eine Allophanat-Gruppe, HDI-Trimerisat-Gruppe, Biuret-Gruppe, Uretdion-Gruppe und/oder Isocyanurat-Gruppe im Molekül aufweisen. Besonders bevorzugt werden Urethanacrylate auf Basis von HDI-Trimerisaten, wie in Desmolux^{®} U680H von der Bayer MaterialScience AG enthalten, sowie Urethanacrylate auf Basis von Allophanaten, wie in Desmolux^{®} XP 2666 von der Bayer MaterialScience AG enthalten, eingesetzt.

Kommerziell erhältlich und weiterhin geeignet im erfindungsgemäßen Sinne sind hier beispielsweise aliphatische Urethanacrylate wie Ebecryl^{®} 4858, Ebecryl^{®} 284, Ebecryl^{®} 265, Ebecryl^{®} 264 (Hersteller jeweils Cytec Surface Specialities), Craynor^{®} 925 von Cray Valley, Viaktin^{®} 6160 von Vianova Resin, Desmolux^{®} U 100 von Bayer MaterialScience AG, Photomer^{®} 6891 von Cognis oder auch in Reaktivverdünnern gelöste aliphatische Urethanacrylate wie Laromer^{®} 8987 (70%ig in Hexandioldiacrylat) von BASF SE, Ludwigshafen, Desmolux^{®} U 680 H (80%ig in Hexandioldiacrylat) von Bayer MaterialScience AG, Craynor^{®} 945B85 (85% in Hexandioldiacrylat) und Craynor^{®} 963B80 (80% in Hexandioldiacrylat) jeweils von Cray Valley oder auch Polyesteracrylate wie Ebecryl^{®} 810 oder 830 von Cytec Surface Specialities.

Bezogen auf den Feststoffgehalt der Nasslackzusammensetzung liegt die gewichtsbezogene Zugabemenge der Komponente A vorzugsweise im Bereich von 0 Gew.-% bis 90 Gew.-%, vorzugsweise im Bereich von 25 Gew.-% bis 75 Gew.-% und insbesondere im Bereich von 25 Gew.-% bis 35 Gew.-% oder im Bereich von 60 Gew.-% bis 70 Gew.-%.

### Komponente B: Reaktivverdünner

Die Herstellung und Verwendung geeigneter Reaktivverdünner gemäß Komponente B sind bekannt und beispielsweise in Chemistry & Technology of UV & EB Formulation for Coatings, Inks & Paints, Vol. 2, 1991, SITA Technology, London (P.K.T: Oldring (Ed.) auf S.237-306 (Reactive Diluents) sowie im Römpp Lexikon Chemie, 5.491, 10. Aufl. 1998, Georg-Thieme-Verlag, Stuttgart beschrieben. Geeignet im erfindungsgemäßen Sinne sind hier beispielsweise Methandioldiacrylat, 1,2-Ethandioldiacrylat, 1,3-Propandioldiacrylat, 1,2-Propandioldiacrylat, Glycerintriacrylat, 1,4-Butandioldiacrylat, 1,3-Butandioldiacrylat, 1,2,4-Butantrioltriacrylat, 1,5-Penandioldiacrylat, Neopentylglykoldiacrylat, Pentaerythritoltriacrylat, Pentaerythritoltetraacrylat, 1,6-Hexandioldiacrylat, Trimethylolpropandiacrylat, Trimethylolpropantriacrylat, Tricyclodecandimethanoldiacrylat, Diethylenglykoldiacrylat, Triethylenglykoldiacrylat, Tetraethylenglykoldiacrylat, Dipropylenglykoldiacrylat, Tripropylenglykoldiacrylat, Trimethylolpropantriethoxytriacrylat, Dipentaerythritolpentaacrylat, Dipentaerythritolhexaacrylat, Ditrimethylolpropantetraacrylat und die entsprechenden Methacrylatderivate bzw. deren Mischungen.

Bevorzugt werden 1,6-Hexandioldiacrylat, Tricyclodecandimethanoldiacrylat, Trimethylolpropantriacrylat, Pentaerythritoltetraacrylat und deren Methacrylatderivate und/oder Mischungen der vorgenannten Reaktivverdünner eingesetzt.

Besonders bevorzugt wird 1,6-Hexandioldiacrylat sowie Trimethylolpropantriacrylat eingesetzt.

Bezogen auf den Feststoffgehalt der Nasslackzusammensetzung liegt die gewichtsbezogene Zugabemenge der Komponente B vorzugsweise im Bereich von 0 Gew.-% bis 90 Gew.-%, vorzugsweise im Bereich von 15 Gew.-% bis 75 Gew.-% und insbesondere im Bereich von 15 Gew.-% bis 35 Gew.-% oder im Bereich von 60 Gew.-% bis 70 Gew.-%.

### Komponente C: Isocyanatgruppen enthaltende Acrylate

Als Ausgangsverbindungen zur Herstellung der Komponente C werden aromatische, araliphatische, aliphatische und cycloaliphatische Di- oder Polyisocyanate verwendet. Es können auch Mischungen solcher Di- oder Polyisocyanate eingesetzt werden. Beispiele geeigneter Di-oder Polyisocyanate sind Butylendiisocyanat, Hexamethylendiisocyanat (HDI), Isophorondiisocyanat (IPDI), 2,2,4- und/oder 2,4,4-Trimethylhexamethylendiisocyanat, die isomeren Bis(4,4'-isocyanatocyclohexyl)-methane und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat, Triphenylmethan-4,4',4"-triisocyanat oder deren Derivate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur und Mischungen derselben. Bevorzugt sind Polyisocyanate auf Basis oligomerisierter und/oder derivatisierter Diisocyanate, die durch geeignete Verfahren von überschüssigem Diisocyanat befreit wurden, insbesondere die des Hexamethylendiisocyanat, Isophorondiisocyanat und der isomeren Bis(4,4'-isocyanatocyclohexyl)methane sowie deren Mischungen. Bevorzugt sind die oligomeren Isocyanurate, Uretdione, Allophanate und Iminooxadiazindione des HDI, des IPDI und/oder der isomeren Bis(4,4'-isocyanatocyclohexyl)methane sowie deren Mischungen. Besonders bevorzugt sind die oligomeren Isocyanurate, Uretdione und Allophanate des IPDI sowie die oligomeren Isocyanurate der isomeren Bis(4,4'-isocyanatocyclohexyl)methane.

Sofern die oben genannten Isocyanate keine isocyanat-reaktiven ethylenisch ungesättigten Funktionalitäten enthalten, sind sie ganz oder teilweise mit isocyanat-reaktiven ethylenisch ungesättigten Verbindungen umgesetzt zu verwenden. Bevorzugt werden hierzu α,β-ungesättigte Carbonsäurederivate wie Acrylate, Methacrylate, Maleinate, Fumarate, Maleimide, Acrylamide, sowie Vinylether, Propenylether, Allylether und Dicyclopentadienyl-Einheiten enthaltende Verbindungen, die mindestens eine gegenüber Isocyanaten reaktive Gruppe aufweisen, eingesetzt, besonders bevorzugt sind dies Acrylate und Methacrylate mit mindestens einer isocyanatreaktiven Gruppe. Als hydroxyfunktionelle Acrylate oder Methacrylate kommen beispielsweise Verbindungen wie 2-Hydroxyethyl(meth)acrylat, Polyethylenoxid-mono(meth)acrylate, Polypropylenoxidmono(meth)-acrylate, Polyalkylenoxidmono(meth)acrylate, Poly("epsilon"-caprolacton)mono(meth)-acrylate, wie Tone^{®} M100 (Dow, USA), 2-Hydroxypropyl(meth)acrylat, 4-Hydroxybutyl(meth)acrylat, 3-Hydroxy-2,2-dimethylpropyl(meth)acrylat, die hydroxyfunktionellen Mono-, Di-oder Tetra(meth)acrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische in Betracht. Darüber hinaus sind isocyanatreaktive oligomere oder polymere ungesättigte Acrylat- und/oder Methacrylatgruppen enthaltende Verbindungen alleine oder in Kombination mit den vorgenannten monomeren Verbindungen geeignet.

Es ist gegebenenfalls auch möglich, die vorgenannten Isocyanate bzw. umgesetzten Isocyanate teilweise mit dem Fachmann aus der Beschichtungstechnologie bekannten Blockierungsmitteln umgesetzt zu verwenden. Beispiele für Blockierungsmittel seien Alkohole, Lactame, Oxime, Malonester, Alkylacetoacetate, Triazole, Phenole, Imidazole, Pyrazole sowie Amine, wie Butanonoxim, Diisopropylamin, 1,2,4-Triazol, Dimethyl-1,2,4-triazol, Imidazol, Malonsäurediethylester, Acetessigester, Acetonoxim, 3,5-Dimethylpyrazol, epsilon-Caprolactam, N-tert.-Butyl-benzylamin, Cyclopentanoncarboxyethylester oder beliebige Gemische dieser Blockierungsmittel genannt.

Als Komponente C können alle vorgenannten Verbindungen bzw. die Umsetzungsprodukte der vorgenannten Verbindungen einzeln oder in beliebigen Mischungen verwendet werden, unter der Voraussetzung, dass sie mindestens eine Isocyanatgruppe und zusätzlich mindestens eine ethylenisch ungesättigte Funktion, die unter Einwirkung aktinischer Strahlung mit ethylenisch ungesättigten Verbindungen unter Polymerisation reagiert, aufweisen.

Bevorzugt werden Isocyanatgruppen-haltige Acrylate wie Desmolux^{®} D100 (Bayer MaterialScience AG) oder Laromer^{®} LR9000 (BASF SE, Ludwigshafen) eingesetzt.

Bezogen auf den Feststoffgehalt der Nasslackzusammensetzung liegt die gewichtsbezogene Zugabemenge der Komponente C vorzugsweise im Bereich von 0 Gew.-% bis 90 Gew.-% enthalten, vorzugsweise im Bereich von 5 Gew.-% bis 70 Gew.-% und insbesondere im Bereich von 10 Gew.-% bis 40 Gew.-%.

### Komponente D: UV-Absorber

Gemäß einer bevorzugten Ausführungsform des erfindungsgemäßen Verfahrens enthält die als Nasslack aufzubringende Zusammensetzung für eine Funktionsschicht mindestens einen UV-Absorber. Eine solche Zusammensetzung kann auch Gemische von UV-Absorbern enthalten. Sind mehrere Schichten auf dem Kunststoffsubstrat aufgebracht werden, können UV-Absorber in mehr als einer Schicht enthalten sein. Der Begriff "UV-Absorber" im Sinne der Erfindung wird synonym mit "Lichtschutzmittel" verwendet.

Der Einsatz von Lichtschutzmitteln und die verschiedenen Typen sind beispielhaft beschrieben in A. Valet, Lichtschutzmittel für Lacke, Vincentz Verlag, Hannover, 1996. Eingesetzt werden können alle geeigneten organischen Lichtschutzmittel, beispielsweise Benzophenone, Resorcinole, Benzotriazole, Oxalsäureanilide, Cyanoacrylate, Triazine, Biphenyltriazine und Zimtsäurederivate sowie die Derivate der vorgenannten Lichtschutzmittel und Mischungen aus allen vorgenannten Lichtschutzmitteln in beliebigem Mischungsverhältnis. Insbesondere sind die UV-Absorber ausgewählt aus der Gruppe, bestehend aus Triazinen, Biphenyltriazinen, Benztriazolen und Resorcinen.

UV-Absorber aus der Klasse der Hydroxybenzophenone sind z.B. Chimasorb^{®} 81 (2-Benzoyl-5-octyloxyphenol (CAS No. 1843-05-6) der Firma BASF SE, Ludwigshafen, 2,4-Dihydroxybenzophenon (CAS No. 131-56-6), 2-Hydroxy-4-(n-octyloxy)benzophenon (CAS No. 1843-05-6), 2-Hydroxy-4-dodecyloxybenzophenon (CAS No. 2985-59-3).

UV-Absorber aus der Klasse der Benzotriazole sind z.B. Tinuvin^{®} 171 (2-[2-Hydroxy-3-dodecyl-5-methylbenzyl)phenyl]-2H-benztriazol (CAS No. 125304-04-3), Tinuvin^{®} 234 (2-[2-Hydroxy-3,5-di(1,1-dimethylbenzyl)phenyl]-2H-benztriazol (CAS No. 70321-86-7)), Tinuvin^{®} 328 (2-2[Hydroxy-3,5-di-tert.amyl-phenyl)-2H-benztriazol (CAS No. 25973-55-1).

UV-Absorber aus der Klasse der Oxalsäureanilide sind z.B. Sanduvor^{®} 3206 (N-(2-Ethoxyphenyl)-ethandiamid (CAS No. 82493-14-9)) von Clariant oder N-(2-Ethoxyphenyl)-N'-(4-dodecylphenyl)oxamide (CAS No. 79102-63-9).

UV-Absorber aus der Klasse der Triazine sind beispielsweise 2-[2-Hydroxy-4-(2-ethylhexyl)oxy]phenyl-4,6-di(4-phenyl)phenyl-1,3,5-t**riazin**, 2-[2-Hydroxy-4-[(octyloxycarbonyl)ethylidenoxy]phenyl-4,6-di(4-phenyl)phenyl-1,3 ,5-triazin, 2-[2-Hydroxy-4-[3-(2-ethylhexyl-1-oxy)-2-hydroxypropyloxy]phenyl]-4,6-bis(2,4-di methylphenyl)-1,3,5-triazin (CAS No. 137658-79-8) auch bekannt als Tinuvin^{®} 405 (BASF SE, Ludwigshafen), 2-[4,6-bis(2,4-dimethylphenyl)-1,3,5-triazin-2-yl]-5-[2-hydroxy-3-(dodecyloxy- and tridecyloxy)propoxy]phenol (CAS No.192662-79-6) auch bekannt als Tinuvin^{®} 400 (BASF SE, Ludwigshaven), 2,4-Diphenyl-6-[2-hydroxy-4-(hexyloxy)phenyl]-1,3,5-triazin (CAS No. 147315-50-2) erhältlich als Tinuvin^{®} 1577 (BASF SE, Ludwigshafen). Die Verbindung 2-[2-Hydroxy-4-(2-ethylhexyl)oxy]phenyl-4,6-di(4-phenyl)phenyl-1,3,5-triazin hat die CAS No. 204848-45-3 und ist erhältlich von BASF SE, Ludwigs**hafen**, **unter dem Namen Tinuvin^{®}** 479. Die Verbindung 2-[2-Hydroxy-4-[(octyloxycarbonyl)ethylidenoxy]phenyl-4,6-di(4-phenyl)phenyl-1,3,5-triazin hat die CAS No. 204583-39-1 und ist erhältlich von BASF SE, Ludwigshafen, unter dem Namen Tinuvin^{®} 1600. Besonders bevorzugte Lichtschutzmittel im erfindungsgemäßen Sinne werden Lichtschutzmittel gemäß der nachfolgenden Formel (I) eingesetzt, 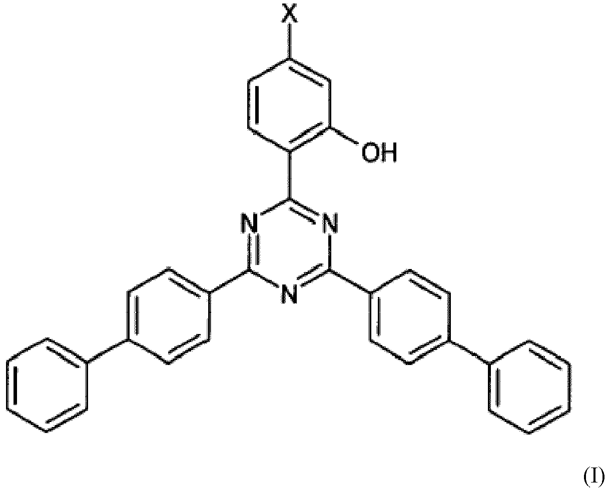 wobei
X = OR⁶, OCH₂CH₂OR⁶, OCH₂CH(OH)CH₂OR⁶ oder OCH(R⁷)COOR⁸, bevorzugt OCH(R⁷)COOR⁸,
R⁶ = verzweigtes oder unverzweigtes C₁-C₁₃-Alkyl, C₂-C₂₀-Alkenyl, C₆-C₁₂-Aryl oder -CO-C₁-C₁₈-Alkyl,
R⁷ = H oder verzweigtes oder unverzweigtes C1-C8-Alkyl, bevorzugt CH₃ und
R⁸ = C₁-C₁₂-Alkyl; C₂-C₁₂-Alkenyl oder C#-C₆-Cycloalkyl, bevorzugt C₈H₁₇ sind.

Ganz besonders bevorzugt wird ein Lichtschutzmittel gemäß der Formel (I) mit X = OCH(R⁷)COOR⁸, R⁷ = CH₃ und R⁸ = C₈H₁₇ (UV-Absorber Tinuvin^{®} 479 der Firma BASF SE, Ludwigshafen) eingesetzt.

Die biphenylsubstituierten Triazine der allgemeinen Formel (I) sind aus WO 96/28431 A1, DE 197 39 797 A1, WO 00/66675 A1, US 6 225 384 A, US 6 255 483 A und DE 101 35 795 A1 prinzipiell bekannt.

In einer bevorzugten Ausführungsform weisen die Lichtschutzmittel eine hohe UV-Absorption im Bereich der größten Empfindlichkeit der Substratschicht auf, besonders bevorzugt besitzen die Lichtschutzmittel ein UV-Absorptionsmaximum im Bereich von 300 nm bis 340 nm.

In den erfindungsgemäß erzeugten Lackschichten können auch anorganische UV-Absorber enthalten sein. Geeignete anorganische UV-Absorber sind beispielsweise Titandioxid, Zinkoxid, Ceroxid, Aluminiumzinnoxid, Indiumzinnoxid, Aluminiumzinkoxid, Siliciumoxid sowie Mischungen und Dotierungen der zuvor aufgeführten Metalloxide. Besonders geeignete anorganische UV-Absorber sind Titandioxid, Zinkoxid und Ceroxid.

Die Zugabemenge des UV-Absorbers sollte so gewählt werden, dass eine möglichst hohe Extinktion im Bereich des UV-Absorptionsmaximums zwischen 300 nm und 340 nm resultiert. Bevorzugte Zugabemengen der Komponente D liegen im Bereich von 0,01 Gew.-% bis 10,0 Gew.-% bezogen auf das Gesamtgewicht des Nasslacks. Besonders bevorzugt liegt die Zugabemenge des UV-Absorbers im Bereich von 0,1 Gew.-% bis 7,0 Gew.-% bezogen auf das Gesamtgewicht des Nasslacks. Insbesondere liegt die Zugabemenge des UV-Absorbers im Bereich von 0,2 Gew.-% bis 5,0 Gew.-%, bezogen auf das Gesamtgewicht des Nasslacks.

### Komponente E: Fotoinitiator

Fotoinitiatoren sind durch aktinische Strahlung aktivierbare Initiatoren, die eine radikalische Polymerisation der entsprechenden polymerisierbaren Gruppen auslösen. Es können übliche, kommerziell erhältliche Fotoinitiatoren eingesetzt werden, wobei zwischen unimolekularen (Typ I) und bimolekularen (Typ II) Initiatoren unterschieden wird. (Typ I)-Systeme sind beispielsweise aromatische Ketonverbindungen, wie Benzophenone in Kombination mit tertiären Aminen, Alkylbenzophenone, 4,4'-Bis(dimethylamino)benzophenon (Michlers Keton), Anthron und halogenierte Benzophenone oder Mischungen der genannten Typen.

Weiterhin geeignet sind (Typ II)-Initiatoren wie Benzoin und seine Derivate, Benzilketale, Acylphosphinoxide, z.B. 2,4,6-Trimethyl-benzoyl-diphenylphosphinoxid, Bisacylphosphinoxide, Phenylglyoxylsäureester, Campherchinon, α-Aminoalkylphenone, α,α-Dialkoxyacetophenone und α-Hydroxyalkylphenone. Je nach zur Härtung verwendeter Strahlungsquelle muss Typ und Konzentration an Fotoinitiator in dem Fachmann bekannter Weise angepasst werden, dabei kann es auch vorteilhaft sein, Gemische dieser Verbindungen einzusetzen. Näheres ist zum Beispiel in P.K.T. Oldring (Ed.), Chemistry & Technology of UV & EB Formulations For Coatings, Inks & Paints, Vol. 3, 1991, SITA Technology, London, S. 61-328 beschrieben. Geeignete Initiatoren sind kommerziell erhältlich beispielsweise unter der Bezeichnung Irgacure^{®} und Darocur^{®} (BASF SE, Ludwigshafen) sowie Esacure^{®} (Fratelli Lamberti, Adelate, IT) und Lucirin^{®} (BASF SE, Ludwigshafen). Bevorzugt werden 1-Hydroxy-cyclohexyl-phenyl-keton (Irgacure^{®} 184 der BASF SE, Ludwigshafen) und 2,4,6-Trimethylbenzoylphenyl-phosphinsäureethylester (Lucirin^{®} TPO-L der BASF SE, Ludwigshafen) sowie Bis(2,4,6-trimethylbenzoyl)phenylphosphinoxid (Irgacure^{®} 819 von der BASF SE, Ludwigshafen) in beliebigem Mischungsverhältnis und in einer Gesamtmenge von 1 Gew.-% bis 10 Gew.-%, bezogen auf das Gesamtgewicht des trockenen Lacks, eingesetzt. Besonders bevorzugt werden die Fotoinitiatoren in einer Gesamtmenge 2 Gew.-% bis 5 Gew.-% eingesetzt.

### Komponente F: Additive und Hilfsmittel der Nasslackzusammensetzung

Als Komponente F können in der Technologie der Lacke, Farben, Druckfarben, Dichtstoffe und Klebstoffe übliche Zusätze oder Hilfsmittel enthalten sein.

Insbesondere sind dies Stabilisatoren wie sterisch gehinderte Amine (HALS), weiterhin Antioxidantien sowie Lackhilfsmittel, z.B. Antiabsetzmittel, Entschäumungs- und/oder Netzmittel, Verlaufmittel, Weichmacher, Katalysatoren, Hilfslösemittel und/oder Verdicker sowie Pigmente, Farbstoffe und/oder Mattierungsmittel.

Als Komponente F können weiterhin unfunktionelle Polymere und Füllstoffe zur Einstellung der mechanischen und optischen Eigenschaften enthalten sein. Hierzu eignen sich alle Polymere und Füllstoffe, die mit dem Beschichtungsmittel verträglich und mischbar sind. Die Verbindungen der Komponente F können sowohl als Bulkmaterial als auch in Form von Partikeln mit mittleren Durchmessern im Bereich zwischen einem und 10000 Nanometern, bevorzugt im Bereich von einem bis 500 Nanometem, besonders bevorzugt im Bereich von zwei bis 200 Nanometern, eingesetzt werden.

Als polymere Zusatzstoffe kommen Polymere wie beispielsweise Polyacrylate, Polycarbonate, Polyurethane, Polyolefine, Polyether, Polyester, Polyamide und Polyharnstoffe in Frage.

Als Füllstoffe können mineralische Füllstoffe, Glasfasern und/oder metallische Füllstoffe, wie sie in gängigen Rezepturen für sogenannte Metalliclackierungen zum Einsatz kommen, verwendet werden.

Als Komponente F im erfindungsgemäßen Sinne können weiterhin Lösemittel oder Lösemittelgemische enthalten sein, die in dem Maße mit der zweiten Schicht verträglich sein müssen, sowie in dem Maße ein Dispergieren, Applizieren und Ablüften der Lackformulierung ermöglichen müssen, dass nach UV Härtung der Lackformulierung zur eigentlichen ersten Schicht ein mehrschichtiges Erzeugnis mit hoher Transparenz und geringer Trübung erhalten wird. Hier kann es sich beispielsweise und vorzugsweise um Alkane, Alkohole, Ester, Ketone oder Mischungen der genannten handeln. Besonders bevorzugt werden Alkohole (mit Ausnahme von Methanol), Essigsäureethylester, Essigsäurebutylester und Butanon eingesetzt werden. Ganz besonders bevorzugt sind Lösemittel oder Lösemittelgemische ausgewählt aus mindestens einem der Gruppe bestehend aus Diacetonalkohol 1 (CH₃)₂C(OH)CH₂C(=O)CH₃, Essigsäureethylester, Essigsäurebutylester, Methoxypropanol und Butanon.

### Plasma

Ein Plasma im Sinne dieser Anmeldung ist ein Gas, dessen Bestandteile teilweise oder vollständig in Ionen und Elektronen "aufgeteilt" ist. Das bedeutet, ein Plasma enthält freie Ladungsträger. Ein Niederdruckplasma ist ein Plasma, in dem der Druck erheblich niedriger als der Erdatmosphärendruck ist. Niederdruckplasmen zählen zu den nichtthermischen Plasmen, das heißt die einzelnen Bestandteile des Plasmas (Ionen, Elektronen, Neutralteichen) stehen nicht im thermischen Gleichgewicht miteinander. Typische technische Niederdruckplasmen werden im Druckbereich kleiner 100mbar betrieben, also bei Drücken, die um einen Faktor 10 geringer sind als der normale Luftdruck. Bei technischen Niederdruckplasmen werden durch selektive Anregung der Elektronen Elektronentemperaturen von einigen Elektronenvolt (mehreren 10.000 K) erreicht, während die Temperatur des Neutralgases wenig über Zimmertemperatur liegt. Dadurch können auch thermisch sensible Materialien wie Kunststoffe mittels Niederdruckplasmen bearbeitet werden. Die Wechselwirkung des Plasmas mit dem Werkstück findet dabei einfach durch in Kontakt bringen statt.

Geeignete Verfahren im Sinne dieser Anmeldung zur Erzeugung eines technischen Plasmas sind solche die mittels elektrischer Entladung bei gegenüber dem Normaldruck von 1013 mbar verringertem Druck unter Einsatz einer Gleichspannung, einer Hochfrequenz- oder Mikrowellenanregung gezündet werden. Diese Verfahren sind in der Technik unter der Bezeichnung Niederdruck oder Niedertemperaturplasma bekannt.

In einer bevorzugten Ausführungsform der Erfindung wird zur Härtung des Nasslacks ein Mikrowellenplasma verwendet. Das zur Abscheidung der ersten mittels plasmagestützten Gasphasenabscheidung aufgebrachten Funktionsschicht eingesetzte Plasma ist vorzugsweise ein Mikrowellenplasma.

Bei dem Niederdruckplasmaverfahren befindet sich das zu behandelnde Werkstück in einer mittels Pumpen evakuierbaren Vakuumkammer. Diese Vakuumkammer umfasst mindestens eine Elektrode, wenn das Plasma durch elektrische Anregung mittels Gleichspannung oder durch Hochfrequenzfelder angeregt wird. Als Anregungsfrequenz können z.B. dienen: etwa 13,56 MHz, etwa 27,12 MHz oder bevorzugt etwa 2,45 GHz. Für den bevorzugten Fall, dass die Anregung mittels Mikrowellenstrahlung erfolgt, könnte sich zum Beispiel an einer Stelle der Kammerwand ein Bereich befinden, welcher für Mikrowellenstrahlung durchlässig ist und durch welchen die Mikrowellenstrahlung in die Kammer eingekoppelt wird. Eine andere bevorzugte Möglichkeit besteht darin, die Mikrowellenleistung entlang einer mikrowellendurchlässigen Röhre, beispielsweise aus Quarzglas, einzukoppeln. Eine derartige Anordnung heißt Duo-Plasmaline (*Muegge Electronic,* Reichelsheim, Germany). Diese Mikrowellenquellen werden typischerweise durch zwei 2,45 GHz-Magnetrons betrieben. Das Plasma brennt dann entlang der Röhren und lässt sich so leicht auf große Werkstücke ausdehnen.

Dazu wird in die evakuierte Vakuumkammer ein geeignetes Prozessgas, bevorzugt N₂ oder He oder eine Mischung daraus, eingelassen, bis ein Druck kleiner als 1013 mbar, vorzugsweise von 10⁻³ mbar bis 10 mbar, besonders bevorzugt 10⁻² mbar bis 1 mbar erreicht ist. Anschließend wird das Plasma mittels Anlegen eines elektrischen Feldes gezündet und für einen gewünschten Zeitraum aufrechterhalten. Die Dauer der Plasmabehandlung beträgt 1 Sekunde bis 10 Minuten, vorzugsweise 2 Sekunden bis 5 Minuten, besonders bevorzugt 3 Sekunden bis 2 Minuten.

Da Gasmoleküle sehr beweglich sind und die das Plasma erzeugende elektrische Entladung nahezu gleichmäßig den gesamten Rezipienten ausfüllt, eignet sich ein Plasma sehr gut zur gleichmäßigen Behandlung von kompliziert geformten Werkstücken mit Bohrungen, Hinterschneidungen oder ähnlichem. Ebenso ist es möglich, flache Formkörper bei Verwendung einer geeigneten Halterung in einem Prozessschritt beidseitig zu behandeln.

Das im erfindungsgemäßen Verfahren zur Härtung des Lacks eingesetzte Plasma kann beispielsweise für eine Dauer im Bereich von 1 Sekunde bis 10 Minuten gezündet werden. Bevorzugt wird das zur Härtung des Lacks eingesetzte Plasma im Bereich von 2 Sekunden bis 5 Minuten, insbesondere von 3 Sekunden bis 2 Minuten, gezündet.

Das im erfindungsgemäßen Verfahren eingesetzte Plasmagas zum Härten des Nasslacks ist vorzugsweise Stickstoff, Helium oder ein Gemisch beider Gase.

Gemäß einer Ausführungsform des erfindungsgemäßen Verfahrens kann das Kunststoffsubstrat beidseitig beschichtet werden. Die Nasslackschichten können gleichzeitig oder nacheinander aufgetragen und durch Einwirkung eines Plasmas gehärtet werden. Auf beiden Seiten kann zusätzlich vor Auftrag des Nasslacks eine andere Funktionsschicht durch Gasphasenabscheidung aufgebracht werden. Für eine beidseitige Beschichtung mit Funktionsschichten ist das erfindungsgemäße Verfahren besonders vorteilhaft, weil die Arbeitsschritte zur Neupositionierung des Kunststoffsubstrats minimiert werden können.

Bei der zeitgleichen beidseitigen Beschichtung kann auf gegenüberliegenden Seiten jeweils eine Lackquelle und eine Plasmaquelle angeordnet werden. Mit diesem Aufbau können die Funktionsgemäß Nasslackschichten zeitgleich aufgetragen und mit einem Plasma erhärtet werden. Bei diesem Verfahrensaufbau mit Lack- und Plasmaquellen auf beiden Seiten muss das Kunststoffsubstrat zwischen den Beschichtungen der einzelnen Seiten nicht mehr bewegt werden.

Darüber hinaus ist es mit dem erfindungsgemäßen Verfahren möglich, das Kunststoffsubstrat auf beiden Seiten mit einem Nasslack zu beschichten und diesen dann mit einem Plasma zu härten. Die beidseitige Beschichtung kann gleichzeitig oder nacheinander geschehen.

Das erfindungsgemäße Verfahren erlaubt, in der Vakuumkammer bei Niederdruckbedingungen mittels plasmainduzierter Gasphasenabscheidung auf die Nasslackschicht eine weitere Funktionsschicht aufzubringen. Eine oder mehrere weitere Schichten können also auf der Nasslackschicht angeordnet sein. Eine weitere Funktionsschicht kann nach der Härtung des Nasslacks mit plasmagestützter Gasphasenabscheidung aufgetragen werden. Das erfindungsgemäße Verfahren hat hier den Vorteil, dass das Kunststoffsubstrat nicht zwischen unterschiedlichen Behandlungseinheiten transportiert werden muss.

Die durch plasmainduzierte Gasphasenabscheidung erfindungsgemäß aufgebrachten Funktionsschichten sollen Kratzfestigkeit verleihen. Beispielsweise kann die erste durch plasmainduzierte Gasphasenabscheidung aufgebrachte Funktionsschicht, auf die der Nasslack appliziert wird, eine Kratzfestigkeit verleihende Schicht sein. Ferner kann die auf die Nasslackfunktionsschicht durch plasmainduzierte Gasphasenabscheidung aufgebrachte Funktionsschicht eine Kratzfestigkeit verleihende Schicht sein.

Für das in der plasmainduzierten Gasphasenabscheidung verwendete Niederdruckplasma kann der Druck im Bereich von 10⁻⁵ mbar bis 100 mbar liegen. Besonders bevorzugt liegt der Druck bei der plasmainduzierten Gasphasenabscheidung im Bereich von 10⁻² mbar bis 10 mbar, insbesondere im Bereich von 0,1 mbar bis 1 mbar.

### Plasmapolymerisation

Zur Abscheidung von Kratzfestschichten im Plasma werden Plasmapolymerisationsprozesse eingesetzt Im Sinne dieser Anmeldung wird Plasmapolymerisation synonym mit plasmagestützer oder plasmainduzierter Gasphasenabscheidung (PECVD) verwendet. Hierbei werden dampfförmige Vorläuferverbindungen (Precursoren) in der Vakuumkammer durch ein Plasma zunächst aktiviert. G. Benz: Plasmapolymerisation: Überblick und Anwendung als Korrosions- und Zerkratzungsschutzschichten. VDI-Verlag GmbH Düsseldorf, 1989 liefert einen Überblick der bekannten Verfahren. Durch die Aktivierung entstehen ionisierte Moleküle und es bilden sich bereits in der Gasphase erste Molekülfragmente in Form von Clustern oder Ketten. Die anschließende Kondensation dieser Fragmente auf der Substratoberfläche bewirkt dann unter Einwirkung von Substrattemperatur, Elektronen- und Ionenbeschuss die Polymerisation und somit die Bildung einer geschlossenen Schicht.

Zur Abscheidung transparenter Kratzfestschichten werden erfindungsgemäß bevorzugt Siloxane in die Vakuumkammer dampfförmig eingebracht und mittels eines O₂-Plasmas zu SiO₂ oxidiert, das sich als glasartige Kratzfestschicht auf dem Substrat niederschlägt. Die auch vorhandenen Anteile wie Kohlenstoff und Wasserstoff reagieren dabei zu kohlenstoffhaltigen Gasen (wie CO, CO₂) und auch zu Wasser ab. Dabei lässt sich durch die Konzentration von Siloxan zum Sauerstoffgas die Härte der Schichten einstellen. Geringe Sauerstoff-Konzentrationen führen dabei eher zu zähen Schichten, während hohe Konzentrationen glasartig harte Schichten erzeugen. Es könnten unter anderem folgende Precursoren eingesetzt werden: Hexamethyldisiloxan, Octamethyltrisiloxan, Decamethyltetrasiloxan, Dodecamethylpentasiloxan, Hexamethylcyclotrisiloxan, Octamethylcyclotetrasiloxan, Decamethylcyclopentasiloxane, Dodecamethylcyclohexasiloxane, Tetramethylcyclotetrasiloxane, Tetraethoxysilan, Tetramethyldisiloxan, Trimethoxymethylsilan, Dimethyldimethoxysilan, Hexamethyldisilazan, Triethoxyphenylsiloxan oder Vinylsilan. Bevorzugt wären Precursoren aus der Gruppe Hexamethyldisiloxan, Octamethylcyclotetrasiloxan, Tetramethylcyclotetrasiloxane, Tetraethoxysilan, Tetramethyldisiloxan, Trimethoxymethylsilan, Dimethyldimethoxysilan, Hexamethyldisilazan, Triethoxyphenylsiloxan oder Vinylsilan.

### Kunststoffsubstrat

Als Kunststoffsubstrat im erfindungsgemäßen Verfahren kann ein thermoplastisch verarbeitbares Material eingesetzt werden. Das als Ausgangsmaterial im erfindungsgemäßen Verfahren eingesetzte thermoplastisch verarbeitbare Material kann auch bereits mit einer Schicht versehen sein.

Thermoplastisch verarbeitbare Kunststoffe im Rahmen der vorliegenden Erfindung sind vorzugsweise Polycarbonat, Co-Polycarbonat, Polyestercarbonat, Polystyrol, Styrol-Copolymere, aromatische Polyester wie Polyethylenterephthalat (PET), PET-Cyclohexandimethanol-Copolymer (PETG), Polyethylennaphthalat (PEN), Polybutylenterephthalat (PBT), aliphatische Polyolefine wie Polypropylen oder Polyethylen, cyclisches Polyolefin, Poly- oder Copolyacrylate und Poly- oder Copolymethacrylat wie Poly- oder Copolymethylmethacrylate (wie PMMA) sowie Copolymere mit Styrol wie transparentes Polystyrolacrylnitril (PSAN), thermoplastische Polyurethane, Polymere auf Basis von zyklischen Olefinen (z.B. TOPAS^{®}, ein Handelsprodukt der Firma Ticona), Polycarbonat Blends mit olefinischen Copolymeren oder Pfropfpolymeren, wie Styrol/Acrylnitril Copolymeren. Die vorgenannten Polymere können einzeln oder in Mischungen eingesetzt werden.

Bevorzugt sind Polycarbonat, Co-Polycarbonat, Polyestercarbonat, aliphatische Polyolefine wie Polypropylen oder Polyethylen, cyclisches Polyolefin, PET oder PETG sowie Poly- oder Copolyacrylate und Poly- oder Copolymethacrylat wie Poly- oder Copolymethylmethacrylate als auch Mischungen vorgenannter Polymere.

Besonders bevorzugt sind Polycarbonat, Co-Polycarbonat, Polyestercarbonat, PET oder PETG sowie Poly- oder Copolyacrylat und Poly- oder Copolymethacrylat wie Poly- oder Copolymethylmethacrylat als auch Mischungen vorgenannter Polymere.

Ganz besonders bevorzugt werden als Kunststoffsubstrat ein Polycarbonat und/oder ein Co-Polycarbonat eingesetzt. Ferner ist auch ein Blendsystem, welches mindestens ein Polycarbonat oder Co-Polycarbonat enthält, bevorzugt.

### Polycarbonate

Polycarbonate im Sinn der Erfindung sind sowohl Homopolycarbonate, Copolycarbonate als auch Polyestercarbonate wie sie in EP 1 657 281 A beschrieben sind.

Die Herstellung aromatischer Polycarbonate erfolgt beispielsweise durch Umsetzung von Diphenolen mit Kohlensäurehalogeniden, vorzugsweise Phosgen und/oder mit aromatischen Dicarbonsäuredihalogeniden, vorzugsweise Benzoldicarbonsäuredihalogeniden, nach dem Phasengrenzflächenverfahren, gegebenenfalls unter Verwendung von Kettenabbrechern, beispielsweise Monophenolen und gegebenenfalls unter Verwendung von trifunktionellen oder mehr als trifunktionellen Verzweigern, beispielsweise Triphenolen oder Tetraphenolen. Ebenso ist eine Herstellung über ein Schmelzepolymerisationsverfahren durch Umsetzung von Diphenolen mit beispielsweise Diphenylcarbonat möglich.

Diphenole zur Herstellung der aromatischen Polycarbonate und/oder aromatischen Polyestercarbonate sind vorzugsweise solche der Formel (I) 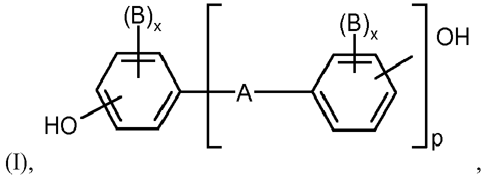 wobei
A eine Einfachbindung, C₁ bis C₅-Alkylen, C₂ bis C₅-Alkyliden, C₅ bis C₆-Cycloalkyli¬den, -O-, -SO-, -CO-, -S-, -SO₂- C₆ bis C₁₂-Arylen, an das weitere aromatische gegebenenfalls Heteroatome enthaltende Ringe kondensiert sein können,
oder ein Rest der Formel (II) oder (III) 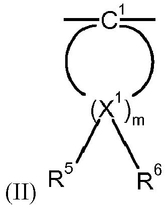 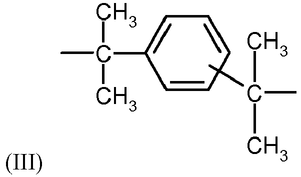
- B: jeweils C₁ bis C₁₂¬¬-Alkyl, vorzugsweise Methyl, Halogen, vorzugsweise Chlor und/oder Brom
- x: jeweils unabhängig voneinander 0, 1 oder 2,
- p: 1 oder 0 sind, und
- R⁵ und R⁶: für jedes X¹ individuell wählbar, unabhängig voneinander Wasserstoff oder C₁ bis C₆-Alkyl, vorzugsweise Wasserstoff, Methyl oder Ethyl,
- X¹: Kohlenstoff und
- m: eine ganze Zahl von 4 bis 7, bevorzugt 4 oder 5 bedeuten, mit der Maßgabe, dass an mindestens einem Atom X¹, R⁵ und R⁶ gleichzeitig Alkyl sind.

Für die Herstellung der Polycarbonate geeignete Diphenole sind beispielsweise Hydrochinon, Resorcin, Dihydroxydiphenyle, B i s-(hydroxyphenyl)-alkane, Bis(hydroxyphenyl)-cycloalkane, Bis-(hydroxyphenyl)-sulfide, Bis-(hydroxyphenyl)-ether, Bis-(hydroxyphenyl)-ketone, Bis-(hydroxyphenyl)-sulfone, Bis-(hydroxyphenyl)-sulfoxide, alpha-alpha'-bis-(hydroxyphenyl)-diisopropylbenzole, Phtalimidine abgeleitet von Isatin- oder Phenolphthaleinderivaten sowie deren kernalkylierte und kernhalogenierte Verbindungen.

Bevorzugte Diphenole sind 4,4'-Dihydroxydiphenyl, 2,2-Bis-(4-hydroxyphenyl)-propan, 2,4-Bis-(4-hydroxyphenyl)-2-methylbutan, 1,1-Bis-(4-hdydroxyphenyl)-p-diisopropylbenzol, 2,2-Bis-(3-methyl-4-hydroxyphenyl)-**propan** , 2 , 2-Bis-(3-chlor-4-hydroxyphenyl)-propan, Bis-(3,5-dimethyl-4-hydroxyphenyl)-methan, 2,2-Bis-(3,5-dimethyl-4-hydroxyphenyl)-propan, Bis-(3,5-dimethyl-4-**hydroxyphenyl)-sulfon,** 2,4-Bis-(3,5-dimethyl-4-hydroxyphenyl)-2-methylbutan, 1,1-Bis-(3,5-dimethyl-4-hydroxyphenyl)-p-diisopropylbenzol, 2,2-Bis-(3,5-dichlor-4-hydroxyphenyl)-propan, 2,2-Bis-(3,5-dibrom-4-hydroxyphenyl)-propan, 1,1 -Bis-(4-hydroxyphenyl)-3,3,5-trimethylcyclohexan, und 2-Hydrocarbyl-3,3-Bis(4-Hydroxyaryl)phthalimidine sowie dem Reaktionsprodukt von N-Phenylisatin und Phenol.

Besonders bevorzugte Diphenole sind 2,2-Bis-(4-hydroxyphenyl)-propan, 2,2-Bis-(3,5-dimethyl-4-hydroxyphenyl)-propan, 2,2-Bis-(3,5-dichlor-4-hydroxyphenyl)-propan, 2,2-Bis-(3,5-dibrom-4-hydroxyphenyl)-propan, 1,1-Bis-(4-hydroxyphenyl)-cyclohexan und 1,1-Bis-(4-hydroxyphenyl)-3,3,5-trimethylcyclohexan. Im Fall der Homopolycarbonate ist nur ein Diphenol eingesetzt, im Fall der Co-polycarbonate sind mehrere Diphenole eingesetzt. Geeignete Kohlensäurederivate sind beispielsweise Phosgen oder Diphenylcarbonat.

Geeignete Kettenabbrecher, die bei der Herstellung der Polycarbonate eingesetzt werden können, sind sowohl Monophenole als auch Monocarbonsäuren. Geeignete Monophenole sind Phenol selbst, Alkylphenole wie Kresole, p-tert.-Butylphenol, Cumylphenol, p-n-Octylphenol, p-iso-Octylphenol, p-n-Nonylphenol und p-iso-Nonylphenol, Halogenphenole wie p-Chlorphenol, 2,4-Dichlorphenol, p-Bromphenol und 2,4,6-Tribromphenol, 2,4,6-Trijodphenol, p-Jodphenol, sowie deren Mischungen. Bevorzugte Kettenabbrecher sind Phenol, Cumylphenol und/oder p-tert-Butylphenol.

Besonders bevorzugte Polycarbonate im Rahmen der vorliegenden Erfindung sind Homopolycarbonate auf Basis von Bisphenol A und Copolycarbonate auf Basis der Monomere ausgewählt aus mindestens einem der Gruppe aus Bisphenol A, 1,1-Bis-(4-hydroxyphenyl)-3,3,5-trimethylcyclohexan, 2-Hydrocarbyl-3,3-Bis(4-Hydroxyaryl)phthalimidine und den Reaktionsprodukten aus N-Phenylisatin und Phenol. Die Polycarbonate können in bekannter Weise linear oder verzweigt sein. Der Anteil der Co-Monomere bezogen auf Bisphenol A beträgt im Allgemeinen bis zu 60 Gew.-%, bevorzugt bis zu 50 Gew.-%, besonders bevorzugt 3 bis 30 Gew.-%. Mischungen von Homopolycarbonat und Copolycarbonaten können ebenfalls verwendet werden.

Polycarbonate und Co-Polycarbonate enthaltend 2-Hydrocarbyl-3,3-Bis(4-Hydroxyaryl)phthalimidine als Monomere sind unter anderem bekannt aus EP 1 582 549 A1. Polycarbonate und Co-Polycarbonate enthaltend Bisphenolmonomere basierend auf Reaktionsprodukten aus N-Phenylisatin und Phenol sind beispielsweise in WO 2008/037364 A1 beschrieben.

Ebenfalls geeignet sind Polycarbonat-Polysiloxan-Blockcokondensate. Dabei enthalten die Blockcokondensate bevorzugt Blöcke aus Dimethylsiloxan. Die Darstellung von Polysiloxan-Polycarbonat-Blockkokondensaten ist beispielsweise beschrieben in US 3 189 662 A, US 3 419 634 A sowie EP 0 122 535 A1. Bevorzugt enthalten die Blockcokondensate 1 Gew.-% bis 50 Gew.-%, bevorzugt 2 Gew.-%bis 20 Gew.-% Dimethylsiloxan.

Die thermoplastischen, aromatischen Polycarbonate haben mittlere Molekulargewichte (Gewichtsmittel Mw, gemessen durch GPC (Gelpermeationschromatographie mit Polycarbonatstandard) von 10.000 g/mol bis 80.000 g/mol bevorzugt 14.000 g/mol bis 32.000 g/mol, besonders bevorzugt 18.000 g/mol bis 32.000 g/mol. Im Falle spritzgegossener Polycarbonat-Formteile beträgt das bevorzugte mittlere Molekulargewicht 20.000 g/mol bis 29.000 g/mol. Im Falle von extrudierten Polycarbonat-Formteilen beträgt das bevorzugte mittlere Molekulargewicht 25.000 g/mol bis 32.000 g/mol.

Die thermoplastischen Kunststoffe der Trägerschicht können ferner Füllstoffe enthalten. Füllstoffe haben in der vorliegenden Erfindung die Aufgabe den thermischen Ausdehnungskoeffizienten des Polycarbonates zu verringern sowie die Permeabilität von Gasen und Wasserdampf zu regulieren bevorzugt zu verringern. Als Füllstoffes sind Glaskugeln, Glashohlkugeln, Glasflakes, Ruße, Graphite, Kohlenstoffnanoröhrchen, Quarze, Talk, Glimmer, Silikate, Nitride, Wollastonit, sowie pyrogene oder gefällte Kieselsäuren, wobei die Kieselsäuren BET-Oberflächen von mindestens 50 m²/g (nach DIN 66131/2) aufweisen, geeignet.

Bevorzugte faserförmige Füllstoffe sind metallische Fasern, Kohlenstofffasern, Kunststofffasern, Glasfasern oder gemahlene Glasfasern, besonders bevorzugt sind Glasfasern oder gemahlene Glasfasern.

Bevorzugte Glasfasern sind auch solche, die in der Ausführungsform Endlosfaser (rovings), Langglasfasern und Schnittglasfasern verwendet werden, die aus M-, E-, A-, S-, R- oder C-Glas herstellt werden, wobei E-, A-, oder C-Glas weiter bevorzugt sind. Der Durchmesser der Fasern beträgt bevorzugt 5 µm bis 25 µm, weiter bevorzugt 6 µm bis 20 µm, besonders bevorzugt 7 µm bis 15 µm. Langglasfasern weisen bevorzugt eine Länge von 5 mm bis 50 mm, weiter bevorzugt von 5 mm bis 30 mm, noch weiter bevorzugt von 6 mm bis 15 mm, und besonders bevorzugt von 7 mm bis 12 mm auf; sie sind beispielsweise in der WO 2006/040087 A1 beschrieben. Die Schnittglasfasern weisen bevorzugt zu mindestens 70 Gew.-% der Glasfasern eine Länge von mehr als 60 µm auf. Weitere anorganische Füllstoffe sind anorganische Partikel mit Korngestalt, ausgewählt aus der Gruppe, die sphärische, kubische, tafelförmige, diskusförmige und plättchenförmige Geometrien umfasst. Insbesondere geeignet sind anorganische Füllstoffe mit sphärischer oder plättchenförmig, bevorzugt in feinteiliger und/oder poröser Form mit großer äußerer und/oder innerer Oberfläche. Dabei handelt es sich bevorzugt um thermisch inerte anorganische Materialien insbesondere basierend auf Nitride wie Bornitrid, um Oxide oder Mischoxide wie Ceroxid, Alumimiumoxid, um Carbide wie Wolframcarbid, Siliciumcarbid oder Borcarbid gepulvertem Quarz wie Quarzmehl, amorphes SiO₂, gemahlener Sand, Glaspartikel wie Glaspulver, insbesondere Glaskugeln, Silikate oder Alumosilikate, Graphit, insbesondere hochreiner synthetischer Graphit. Insbesondere bevorzugt sind dabei Quarz und Talk, am stärksten bevorzugt Quarz (sphärische Korngestalt). Diese Füllstoffe sind durch einen mittleren Durchmesser d50% von 0,1 µm bis 10 µm, vorzugsweise von 0,2 µm bis 8,0 µm, weiter bevorzugt von 0,5 µm bis 5 µm, gekennzeichnet.

Silikate sind durch einen mittleren Durchmesser d50 von 2 µm bis 10 µm, vorzugsweise von 2,5 µm bis 8,0 µm, weiter bevorzugt von 3 µm bis 5 µm, und besonders bevorzugt von 3 µm, gekennzeichnet, wobei ein oberer Durchmesser d95% von entsprechend 6 µm bis 34 µm, weiter bevorzugt von 6,5 µm bis 25,0 µm, noch weiter bevorzugt von 7 µm bis 15 µm, und besonders bevorzugt von etwa 10 µm bevorzugt ist. Bevorzugt weisen die Silikate eine spezifische BET-Oberfläche, bestimmt durch Stickstoffadsorption gemäß ISO 9277, von 0,4 m²/g bis 8,0 m²/g, weiter bevorzugt von 2 m²/g bis 6 m²/g, und besonders bevorzugt von 4,4 m²/g bis 5,0 m²/g auf. Weiter bevorzugte Silikate weisen nur maximal 3 Gew.-% Nebenbestandteile auf, wobei vorzugsweise der Gehalt an Al₂O₃ < 2,0 Gew.-%, Fe₂O₃ < 0,05 Gew.-%, (CaO + MgO) < 0,1 Gew.-%,

(Na₂O + K₂O) < 0,1 Gew.-%) ist, jeweils bezogen auf das Gesamtgewicht des Silikats.

Weitere Silikate verwenden Wollastonit oder Talk in Form von fein vermahlenen Typen mit einem mittleren Partikeldurchmesser d50 von kleiner als 10 µm bevorzugt kleiner als 5 µm, besonders bevorzugt < 2 µm, ganz besonders bevorzugt kleiner als 1,5 µm. Die Korngrößenverteilung wird durch Windsichten bestimmt. Die Silikate können eine Beschichtung mit siliciumorganischen Verbindungen haben, wobei bevorzugt Epoxysilan-, Methylsiloxan-, und Methacrylsilan-Schlichten zum Einsatz kommen. Besonders bevorzugt ist eine Epoxysilanschlichte.

Die Füllstoffe können in einer Menge bis zu 40 Gew.-% bezogen auf die Menge an Polycarbonat zugesetzt werden. Bevorzugt sind 2,0 Gew.-% bis 40,0 Gew.-%, besonders bevorzugt 3,0 Gew.-% bis 35,0 Gew.-%.

Als Blendpartner für die thermoplastischen Kunststoffe, insbesondere für Polycarbonate, sind Pfropfpolymerisate von Vinylmonomeren auf Pfropfgrundlagen wie Dienkautschuke oder Acrylatkautschuke geeignet. Pfropfpolymerisate B sind bevorzugt solche aus B.1 5 Gew.-% bis 95 Gew.-%, vorzugsweise 30 Gew.-% bis 90 Gew.-%, wenigstens eines Vinylmonomeren auf B.2 95 Gew.-% bis 5 Gew.-%, vorzugsweise 70 Gew.-% bis 10 Gew.-% einer oder mehrerer Pfropfgrundlagen mit Glasübergangstemperaturen von kleiner 10°C, vorzugsweise kleiner 0°C, besonders bevorzugt kleiner -20°C. Die Pfropfgrundlage B.2 hat im Allgemeinen eine mittlere Teilchengröße (d50-Wert) von 0,05 µm bis 10 µm, vorzugsweise 0,1 µm bis 5 µm, besonders bevorzugt 0,2 µm bis 1 µm. Monomere B.1 sind vorzugsweise Gemische aus B.1.1 50 bis 99 Gew.-Teilen Vinylaromaten und/oder kernsubstituierten Vinylaromaten (wie Styrol, *-Methylstyrol, p-Methylstyrol, p-Chlorstyrol) und/oder Methacrylsäure-(C₁-C₈)-Alkylester, wie Methylmethacrylat, Ethylmethacrylat), und

B.1.2 1 bis 50 Gew.-Teilen Vinylcyanide (ungesättigte Nitrile wie Acrylnitril und Methacrylnitril) und/oder (Meth)Acrylsäure-(C₁-C₈)-Alkylester, wie Methylmethacrylat, n-Butylacrylat, t-Butylacrylat, und/oder Derivate (wie Anhydride und Imide) ungesättigter Carbonsäuren, beispielsweise Maleinsäureanhydrid und N-Phenyl-Maleinimid. Bevorzugte Monomere B.1.1 sind ausgewählt aus mindestens einem der Monomere Styrol, * Methylstyrol und Methylmethacrylat, bevorzugte Monomere B.1.2 sind ausgewählt aus mindestens einem der Monomere Acrylnitril, Maleinsäureanhydrid und Methylmethacrylat. Besonders bevorzugte Monomere sind B.1.1 Styrol und B.1.2 Acrylnitril.

Für die Pfropfpolymerisate B geeignete Pfropfgrundlagen B.2 sind beispielsweise Dienkautschuke, EP(D)M-Kautschuke, also solche auf Basis Ethylen/Propylen und gegebenenfalls Dien, Acrylat-, Polyurethan-, Silikon-, Chloropren und Ethylen/Vinylacetat-Kautschuke. Bevorzugte Pfropfgrundlagen B.2 sind Dienkautschuke, beispielsweise auf Basis Butadien und Isopren, oder Gemische von Dienkautschuken oder Copolymerisate von Dienkautschuken oder deren Gemischen mit weiteren copolymerisierbaren Monomeren (z.B. gemäß B.1.1 und B.1.2), mit der Maßgabe, dass die Glasübergangstemperatur der Pfropfgrundlage B.2 unterhalb 10°C vorzugsweise unterhalb 0°C, besonders bevorzugt unterhalb 10°C liegt. Besonders bevorzugt ist reiner Polybutadienkautschuk.

Besonders bevorzugte Polymerisate B sind beispielsweise ABS-Polymerisate (Emulsions-, Masse- und Suspensions-ABS), wie sie z.B. in der DE 2 035 390 A1 oder in der DE 2 248 242 A1 bzw. in Ullmanns, Enzyklopädie der Technischen Chemie, Bd. 19 (1980), S. 280 ff. beschrieben sind. Der Gelanteil der Pfropfgrundlage B.2 beträgt mindestens 30 Gew.- %, vorzugsweise mindestens 40 Gew.-% (in Toluol gemessen). Die Pfropfcopolymerisate B werden durch radikalische Polymerisation, z.B. durch Emulsions-, Suspensions-, Lösungs- oder Massepolymerisation, vorzugsweise durch Emulsions- oder Massepolymerisation hergestellt. Da bei der Pfropfreaktion die Pfropfmonomeren bekanntlich nicht unbedingt vollständig auf die Pfropfgrundlage aufgepfropft werden, werden unter Pfropfpolymerisaten B auch solche Produkte verstanden, die durch (Co)Polymerisation der Pfropfmonomere in Gegenwart der Pfropfgrundlage gewonnen werden und bei der Aufarbeitung mit anfallen. Die Polymer-Zusammensetzungen können optional noch weitere übliche Polymeradditive enthalten, wie z.B. die in EP 0 839 623 A1, WO 96 15102 A1, EP 0 500 496 A1 oder "Plastics Additives Handbook", Hans Zweifel, 5th Edition 2000, Hanser Verlag, München) beschriebenen Antioxidantien, Thermostabilisatoren, Entformungsmittel, optischen Aufheller, UV Absorber und Lichtstreumittel in den für die jeweiligen Thermoplasten üblichen Mengen.

Als UV-Stabilisatoren sind Benzotriazole, Triazine, Benzophenone und/oder arylierte Cyanoacrylate geeignet. Besonders geeignete UV-Absorber sind Hydroxy-Benzotriazole, wie 2-(3',5'-Bis-(1,1-dimethylbenzyl)-2'-hydroxy-phenyl)-benzotriazol (Tinuvin^{®} 234, BASF SE, Ludwigshafen), 2-(2'-Hydroxy-5'-(tert-octyl)-phenyl)-benzotriazol (Tinuvin^{®} 329, BASF SE, Ludwigshafen), 2-(2'-Hydroxy-3'-(2-butyl)-5'-(tert-butyl)-phenyl)-benzotriazol (Tinuvin^{®} 350, BASF SE, Ludwigshafen), Bis-(3-(2H-benztriazolyl)-2-hydroxy-5-tert.-octyl)methan, (Tinuvin^{®} 360, BASF SE, Ludwigshafen), (2-(4,6-Diphenyl-1,3,5-triazin-2-yl)-5-(hexyloxy)-phenol (Tinuvin^{®} 1577, BASF SE, Ludwigshafen), sowie der Benzophenone 2,4-Dihydroxy-benzophenon (Chimasorb^{®} 22 , BASF SE, Ludwigshafen) und 2-Hydroxy-4-(octyloxy)-benzophenon (Chimasorb^{®} 81, BASF SE, Ludwigshafen), 2-Propensäure, 2-Cyano-3,3-diphenyl-, 2,2-Bis[[(2-cyano-1-oxo-3,3-diphenyl-2-propenyl)oxy]-methyl]-1,3-propanediylester (9CI) (Uvinul^{®} 3030, BASF SE, Ludwigshafen), 2-[2-Hydroxy-4-(2-ethylhexyl)oxy]phenyl-4,6-di(4-phenyl)phenyl-1,3,5-triazin (Tinuvin^{®} 1600, BASF SE, Ludwigshafen) oder Tetra-ethyl-2,2'-(1,4-phenylen-dimethyliden)-bismalonat (Hostavin^{®} B-Cap, Clariant AG). Die Zusammensetzung der thermoplastischen Kunststoffe kann UV-Absorber üblicherweise in einer Menge von 0 Gew.-% bis 10 Gew.-%, bevorzugt 0,001 Gew.-% bis 7,000 Gew.-%, besonders bevorzugt 0,001 Gew.-% bis 5,000 Gew.-% bezogen auf die Gesamtzusammensetzung enthalten. Die Herstellung der Zusammensetzungen der thermoplastischen Kunststoffe erfolgt mit gängigen Einarbeitungsverfahren durch Zusammenführung, Vermischen und Homogenisieren der einzelnen Bestandteile, wobei insbesondere die Homogenisierung bevorzugt in der Schmelze unter Einwirkung von Scherkräften stattfindet. Gegebenenfalls erfolgt das Zusammenführen und Vermischen vor der Schmelzehomogenisierung unter Verwendung von Pulvervormischungen.

Der thermoplastisch verarbeitbare Kunststoff kann zu Formkörpern in Form von Folien oder Platten verarbeitet werden. Die Folie oder die Platte können ein oder mehrschichtig ausgeführt sein und aus verschiedenen oder gleichen Thermoplasten bestehen, z.B. Polycarbonat/PMMA, Polycarbonat/PVDF oder Polycarbonat/PTFE aber auch Polycarbonat/Polycarbonat.

Der thermoplastisch verarbeitbare Kunststoff kann beispielsweise durch Spritzguss oder Extrusion geformt werden. Durch Einsatz von einem oder mehreren Seitenextrudern und einer Mehrkanal-Düse oder gegebenenfalls geeigneten Schmelzeadaptern vor einer Breitschlitzdüse lassen sich thermoplastische Schmelzen verschiedener Zusammensetzung übereinander legen und somit mehrschichtige Platten oder Folien erzeugen (für die Koextrusion siehe beispielsweise EP-A 0 110 221, EP-A 0 110 238 und EP-A 0 716 919, für Details des Adapter- und Düsenverfahrens siehe Johannaber/Ast:"Kunststoff-Maschinenführer", Hanser Verlag, 2000 und in Gesellschaft Kunststofftechnik: "Koextrudierte Folien und Platten: Zukunftsperspektiven, Anforderungen, Anlagen und Herstellung, Qualitätssicherung", VDI-Verlag, 1990). Für die Koextrusion werden bevorzugt Polycarbonate und Poly(meth)acrylate eingesetzt. Besonders bevorzugt werden Polycarbonate eingesetzt.

Die Folie kann verformt und mit einem weiteren Thermoplasten aus den oben genannten Thermoplasten hinterspritzt werden (Film Insert Molding (FIM)). Platten können thermogeformt oder mittels Drape-Forming bearbeitet bzw. kalt eingebogen werden. Auch ist eine Formgebung über Spritzguss-Prozesse möglich. Diese Prozesse sind dem Fachmann bekannt. Die Dicke der Folie oder Platte muss hierbei so beschaffen sein, dass im Bauteil eine hinreichende Steifigkeit gewährleistet ist. Im Falle einer Folie kann diese durch Hinterspritzen verstärkt werden, um eine ausreichende Steifigkeit zu gewährleisten.

Die Gesamtdicke des Formkörpers, hergestellt aus dem thermoplastisch verarbeitbaren Kunststoff, das heißt einschließlich einer möglichen Hinterspritzung oder Koextrusionsschichten, beträgt im Allgemeinen 0,1 mm bis 15 mm. Vorzugsweise beträgt die Dicke der Formkörper 0,8 mm bis 10 mm. Insbesondere beziehen sich die Dickenangaben auf die Gesamtformkörperdicke bei Verwendung von Polycarbonat als Formkörpermaterial einschließlich einer möglichen Hinterspritzung oder Koextrusionsschichten.

### Sprühlackierung

In einer weiteren Ausführungsform der Erfindung erfolgt das Aufbringen des Nasslacks durch Sprühen. Im Sinne der Erfindung werden die Begriffe "Sprühen" und "Spritzen" synonym verwendet. Das Sprühen hat den Vorteil, dass die dafür notwendige Apparatur, nämlich die Düse, in der Vakuumkammer nur wenig Platz einnimmt und somit eine kleine Dimensionierung der Vakuumkammer erlaubt. Darüber hinaus lässt sich das Aufsprühen mit einem geringen Einsatz beweglicher Teile automatisieren.

Bei der Sprüh- oder Spritzapplikation von Beschichtungsmitteln werden feine Lacktröpfchen erzeugt und auf der zu beschichtenden Oberfläche niedergeschlagen. Die Lacktröpfchenerzeugung erfolgt dabei mit Hilfe von Luftdruck durch pneumatische Zerstäubung (Druckluftspritzen), von Flüssigkeitsdruck durch hydraulische Zerstäubung (Airless-Spritzen) bzw. Kombinationen der hydraulischen Zerstäubung mit Luftunterstützung (Airmix-Zerstäubung), von Zentrifugalkräften (Hochrotationszerstäubung) oder elektrischen Kräften (elektrostatisch unterstütztes oder rein elektrostatisches Sprühen).

Im erfindungsgemäßen Verfahren wird bevorzugt die verfahrensweise des Druckluftspritzens verwendet. Unter Druckluftspritzen versteht man ein Verfahren der Lackiertechnik, welches auch als Druckluftzerstäubung, Hochdruckspritzen oder pneumatisches Spritzen bezeichnet wird. Beim Druckluftspritzen erfolgt die Förderung des Beschichtungsmittels aus einer Umluftanlage oder einem Druckkessel, und es wird mechanisch über Düsen versprüht, hauptsächlich im Druckbereich bis 6 bar. Die Zerstäubung des Beschichtungsmittels an einem Düsenkopf mit Hilfe ausströmender Druckluft läuft folgendermaßen ab: Durch eine entsprechende Konstruktion entsteht während des Ausströmens von Druckluft aus dem Düsensystem durch verschiedene Kanäle und am Farbkanal ein Vakuum. Wird nun die Ventilnadel an der Düse zurückgezogen, also das Farbventil geöffnet, so wird das Beschichtungsmaterial aus dem Farbkanal herausgesaugt, und das Beschichtungsmittel gelangt in die Zerstäuberzone. Die Zerstäubungsmaterialeinstellung erfolgt durch die Wahl der Düsengröße, wodurch das mehr oder weniger weite Zurückziehen der Düsennadel somit eine Veränderung des Farbkanalquerschnitts ergibt.

Eine weit verbreitete erfindungsgemäß geeignete Applikationsmethode, die sich aus dem Druckluftspritzen entwickelt hat, ist das Airbrush-Spritzen. Technisch wird hierbei eine Airbrush-Pistole mit einem ein Ein- oder Zweistoffzerstäuber nach dem Prinzip der Strahlpumpe, welche Druckluft als Treibmittel verwendet, genutzt. Das Airless-Spritzen wird auch als luftloses, hydraulisches oder Höchstdruckspritzen bezeichnet. Hierbei handelt es sich um eine Lackiertechnik, bei der das Spritzmaterial unter hohem Druck ohne Zufuhr von Druckluftzerstäubt wird. Die Zufuhr der Beschichtungsmittel wird über Airless-Pumpen, welche je nach Bedarf verschiedene Übersetzungsverhältnisse aufweisen, mittels Förderkolben zur Spritzpistole gedrückt. Die theoretischen Übersetzungsverhältnisse der Pumpen bewegen sich zwischen 25:1 und 75:1. Das Fördervolumen pro Doppelhub des Kolbens bewegt sich zwischen 15 cm³ und 450 cm³, so dass ein maximaler Materialvolumenstrom von bis zu 44 1/min zur Verfügung steht.

Bei dem Airless-Spritzen mit Luftunterstützung, welches auch als Airmix-Zerstäubung bezeichnet wird, handelt e sich um ein Verfahren der Lackiertechnik. Die Kombination des Airless-Spritzens mit Luftunterstützung, in Verbindung mit speziell entwickelten Düsen, ist sowohl für Rund- als auch für Flachstrahl einsetzbar. Erreicht wird ein nebelarmes Airless-Spritzen gehobener Zerstäubungsqualität mit guter Mengenregulierung. Um die Größe der Spritzpartikel zu verkleinern und gleichzeitig deren Vorwärtsgeschwindigkeit zu reduzieren, wurde Multikanalwirbeldüse (MCS) entwickelt. Aus einem schräg eingespeisten Ringkanal werden feine, geradlinige Kanäle versorgt, die tangential in die Düsenöffnung münden. Ausgehend von jedem dieser feinen Kanäle findet hier eine Airless-Zerstäubung statt, die durch die Anordnung bedingt in eine Drehbewegung verwirbelt wird. Dadurch wird einen weiche, sehr gut zerstäubte, runde Sprühwolke erzeugt, die keine Ähnlichkeit mit dem konventionellen Airless-Spritzmittel hat.

Bei der Hochrotationszerstäubung werden sogenannte Hochrotationssprühglocken bzw. -scheiben mit einer maximalen Drehzahl bis zu 60.000 U/min eingesetzt.

Die beim Spritzlackieren eingesetzten elektrostatischen Hochrotationsglocken arbeiten je nach Beschichtungsmaterial und Durchsatzmenge mit Drehzahlen zwischen 15.000 U/min und 60.000 U/min. Sie zerstäuben dabei den radial von der Glockenkante abgeschleuderten Lack mit einer hohen Relativgeschwindigkeit zur Umgebungsluft. Die Aufladung des Beschichtungsmaterials geschieht mit einer Spannung von 50 kV bis 100 kV. Regulieren lässt sich die Lackwolke in Breite und Umfang mit der hinter der Glocke angebrachten sogenannten Luftbrause (Lenkluft).

Hinter dem Zerstäuber sind in ringförmiger Anordnung koaxial zur Rotationsachse Bogenelemente angebracht, die durch die Zugabe von mehr oder weniger Pressluft die Lackwolke mit einem Durchmesser von 150 mm bis 800 mm erscheinen lassen.

Bei dem rein elektrostatischen Sprühen werden üblicherweise Sprühscheiben oder Sprühglocken verwendet. Die Zerstäubung erfolgt dadurch, dass die Lacktröpfchen durch Zentrifugalkräfte abgeschleudert und dann überwiegend durch elektrische Feldkräfte zum Werkstück transportiert werden, wobei ein hoher Auftragswirkungsgrad erzielt werden kann. Pro cm Kantenlänge können bei der Nutzung von Sprühglocken innerhalb von einer Minute bis zu 3 cm³ Beschichtungsmaterial abgezogen werden. Die Umdrehungszahl beträgt dann bis zu 900 U/min.

Die erfindungsgemäße Vorrichtung zur Beschichtung von Kunststoffsubstraten umfasst vorzugsweise einen für das Sprühen unter Niederdruck optimierten Sprühautomaten, der in der Art optimiert wurde, dass die Bedienung des Sprühautomaten von außerhalb der geschlossenen Vakuumkammer erfolgen kann.

Der Abstand zwischen Sprühdüse und Substrat wird im erfindungsgemäßen Verfahren so gewählt sein, dass eine ausreichende Verteilung des Lacks auf der zu beschichtenden Oberfläche erreicht wird. Der Abstand kann im erfindungsgemäßen Verfahren bevorzugt 1 cm bis 70 cm betragen. Abstände kleiner als 1 cm erlauben bei Kunststoffsubstraten durchschnittlicher Größe keine ausreichende Verteilung des Lacks über die gesamte Fläche des Substrats. Abstände über 70 cm sind nachteilig da sie eine größere Dimensionierung der Vakuumkammer notwendig machen. Besonders bevorzugt ist ein Abstand zwischen Sprühdüse und Kunststoffsubstrat im Bereich von 15 cm bis 50 cm, insbesondere im Bereich von 25 cm bis 35 cm. In diesem Bereich wird eine optimale Verteilung des Lacks erreicht.

Als Sprühgase kann ein Inertgas eingesetzt werden. Vorzugsweise sind das Stickstoff, Argon, Helium und deren Gemische.

Das Sprühen kann erfindungsgemäß bevorzugt mit einem Fluss im Bereich von 0,05 l/min bis 4 l/min durchgeführt werden. Nur bei Flusswerten oberhalb von 0,05 l/min kann die Beschichtung in einem verfahrenstechnisch sinnvollen Zeitraum aufgetragen werden. Flüsse oberhalb von 4 l/min erfordern zu hohen Drücke im Bereich der Düse und würde spezielle Düse erfordern, die sehr aufwendig in der Herstellung sind. Besonders bevorzugt liegt der Fluss im Bereich von 0,2 l/min bis 1,0 l/min, insbesondere im Bereich von 0,4 l/min bis 0,6 l/min.

In Abhängigkeit von der Geometrie des Kunststoffsubstrats, dem gewählten Sprühabstand und dem eingestellten Fluss wird die Sprühdauer so gewählt, dass die trockene Nasslackschicht eine bei 340 nm Wellenlänge gemessene optische Dichte von größer oder gleich 0,4 aufweist. Für einen effektiven UV-Schutz sollte der getrocknete Nasslack mindestens eine bei 340 nm gemessene optische Dichte von 0,4 aufweisen. Die dafür geeignete Sprühdauer ist neben dem eingestellten Fluss und dem Abstand von verschiedenen Faktoren, wie der Konzentration des UV-Absorbers im Nasslack, der Geometrie des Kunststoffsubstrats und den Druckbedingungen in der Vakuumkammer abhängig.

In einer bevorzugten Ausführungsform des erfindungsgemäßen Verfahrens findet der Auftrag des Nasslacks unter Niederdruckbedingungen statt. Bei dieser Ausführungsform der Erfindung wird die Kammer schon vor dem Nasslackauftrag auf das Kunststoffsubstrat evakuiert und für das Plasma geeignete Druckbedingungen eingestellt. Der Nasslack kann dann direkt nach Applikation auf das Substrat mit Plasma gehärtet werden.

Wenn der Nasslack im erfindungsgemäßen Verfahren bei Niederdruckbedingungen aufgetragen wird, liegt der Druck bevorzugt bei kleiner oder gleich 100 mbar. Besonders bevorzugt liegt der Druck bei Auftrag des Nasslacks bei kleiner oder gleich 10 mbar, insbesondere im Bereich von 10⁻² mbar bis 5 mbar.

Der Druck in der Vakuumkammer bei Aushärtung des Nasslacks mittels Plasma liegt vorzugsweise im Bereich von 10⁻⁵ mbar bis 100 mbar, besonders bevorzugt im Bereich von 10⁻³ mbar bis 10 mbar, insbesondere im Bereich von 10⁻² mbar bis 1 mbar.

### Figuren

Fig. 1 zeigt schematisch ein Kunststoffsubstrat, das in erfindungsgemäßer Weise einseitig mit zwei Schichten beschichtet ist.
Fig. 2 zeigt schematisch ein Kunststoffsubstrat, das in erfindungsgemäßer Weise einseitig mit drei Schichten beschichtet ist.
Fig. 3 zeigt schematisch ein Kunststoffsubstrat, das in erfindungsgemäßer Weise zweiseitig mit zwei Schichten beschichtet ist.
Fig. 4 zeigt schematisch ein Kunststoffsubstrat, das in erfindungsgemäßer Weise beidseitig mit drei Schichten beschichtet ist.

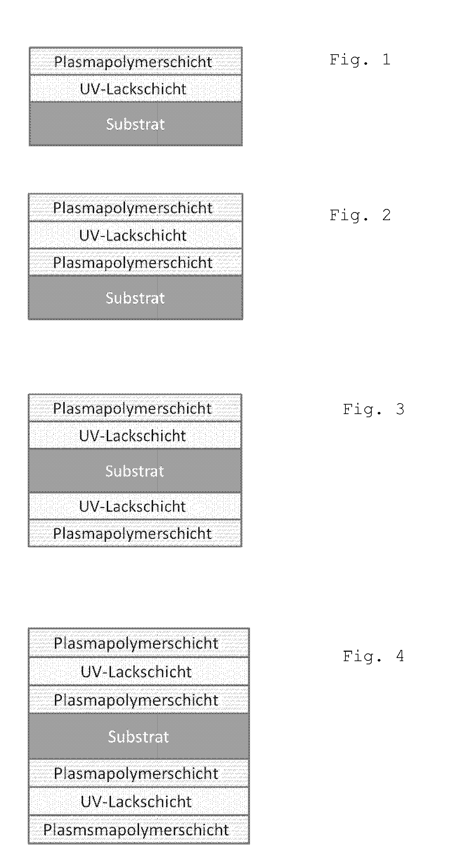

Auf das Kunststoffsubstrat in Fig. 1 wurde zunächst eine UV-Absorber enthaltende Lackschicht aufgesprüht und diese dann gehärtet. Anschließend wurde eine Kratzfestschicht mittels Plasmapolymerisation auf die UV-Schicht aufgetragen.

Das Kunststoffsubstrat nach Fig.2 wurde mittels Plasmapolymerisation mit einer Kratzfestschicht einseitig beschichtet. Anschließend wurde auf die Kratzfestschicht zunächst ein einen UV-Absorber enthaltender Nasslack gesprüht und gehärtet und anschließend eine weitere Kratzfestschicht mittels Plasmapolymerisation abgeschieden. Das Kunststoffsubstrat nach Fig. 4 wurde, wie zuvor für Fig. 2 beschrieben, allerdings beidseitig beschichtet.

Auf das Kunststoffsubstrat der Fig. 3 wurde auf einer Seite zunächst ein Nasslack mit UV-Absorber und darauf anschließend eine Kratzfestschicht mittels Gasphasenabscheidung aufgetragen. Auf die andere Seite des Kunststoffsubstrats wurden dieselben Schichten in gleicher Reihenfolge aufgetragen.

Das beschichtete Kunststoffsubstrat mit UV-Schutzbeschichtung und gegebenenfalls Kratzschutzbeschichtung kann beispielsweise zur Herstellung von Gehäusen für Elektrogeräte, Fensterprofilen, Scheinwerferstreuscheiben, Karosserieelementen, Maschinenabdeckungen, Autoscheiben und Architekturverscheibungen verwendet werden.

Die folgenden Beispiele dienen der weiteren Erläuterung der Erfindung.

### BEISPIELE

In den Beispielen werden folgende Rohstoffe bzw. Materialien verwendet:

| Verwendeter Rohstoff | Hersteller |
|---|---|
| Desmolux^{®} U680H | Bayer MaterialScience AG |
| 1,6-Hexandioldiacrylat | Aldrich |
| Trimethylolpropantriacrylat | Aldrich |
| Irgacure^{®} 184 | BASF SE |
| Irgacure^{®} 819 | BASF SE |
| Lucirin^{®} TPO-L | BASF SE |
| Tinuvin^{®} 479 | BASF SE |
| Butylacetat | Aldrich |
| Makrolon^{®} M2808 | Bayer MaterialScience AG |

### Beispiel 1

In einem Rührgefäß mit Rührer und Rühraggregat wurden der Reihe nach 30,0 Teile 1,6-Hexandioldiacrylat, 70,0 Teile Trimethylolpropantriacrylat, 4,0 Teile Irgacure^{®} 184 und 1,0 Teile Lucirin TPO-L unter stetigem Rühren zudosiert. Nach der vollständigen Zugabe wurde noch weitere 10 min gerührt bis sich eine homogene Beschichtungslösung ergab.

### Beispiel 2

In einem Rührgefäß mit Rührer und Rühraggregat wurden der Reihe nach 30,0 Teile 1,6-Hexandioldiacrylat, 70,0 Teile Trimethylolpropantriacrylat, 2,0 Teile Irgacure^{®} 184 und 2,0 Teile Irgacure^{®} 819 unter stetigem Rühren zudosiert. Nach der vollständigen Zugabe wurde noch weitere 10 min gerührt bis sich eine homogene Beschichtungslösung ergab.

### Beispiel 3

In einem Rührgefäß mit Rührer und Rühraggregat wurden der Reihe nach 30,0 Teile 1,6-Hexandioldiacrylat, 70,0 Teile Trimethylolpropantriacrylat, 2,0 Teile Irgacure^{®} 184, 2,0 Teile Irgacure^{®} 819 und 0,80 Teile Tinuvin^{®} 479 unter stetigem Rühren zudosiert. Nach der vollständigen Zugabe wurde noch weitere 10 min gerührt bis sich eine homogene Beschichtungslösung ergab.

### Beispiel 4

In einem Rührgefäß mit Rührer und Rühraggregat wurden der Reihe nach 133,0 Teile Desmolux^{®} U680H, 2,0 Teile Irgacure^{®} 184 und 2,0 Teile Irgacure^{®} 819 sowie 68,5 Teile Butylacetat unter stetigem Rühren zudosiert. Nach der vollständigen Zugabe wurde noch weitere 10 min gerührt bis sich eine homogene Beschichtungslösung ergab.

### Beispiel 5

In einem Rührgefäß mit Rührer und Rühraggregat wurden der Reihe nach 133,0 Teile Desmolux^{®} U680H, 2,0 Teile Irgacure^{®} 184, 2,0 Teile Irgacure^{®} 819, 68,5 Teile Butylacetat und 1,5 Teile Tinuvin^{®} 479 unter stetigem Rühren zudosiert. Nach der vollständigen Zugabe wurde noch weitere 10 min gerührt bis sich eine homogene Beschichtungslösung ergab.

### Beispiel 6

Herstellung eines Kunststoffsubstrats (Makrolon^{®} M2808 Massivplatten mittels Spritzguss-Verfahren Für die Beschichtungsversuche wurden Spritzguss-Rechteckplatten mit den Maßen 150 x 105 x 3,2 mm mit Seitenanguss in optischer Qualität unter Verwendung von Makrolon^{®} M2808 (lineares Bisphenol-A Polycarbonat der Bayer AG, Leverkusen mit einem Schmelzflussindex (MFR) gemäß ISO 1133 von 10 g/10 min bei 300°C und 1,2 kg Belastung) angefertigt. Die Massetemperatur betrug 300 - 330°C und die Werkzeugtemperatur 100°C. Das jeweilige Granulat wurde vor Verarbeitung fünf Stunden lang im Vakuumtrockenschrank bei 120°C getrocknet.

### Beispiele 7 bis 11

Applikation der Beschichtungslösungen aus Beispiel 1 bis 5 auf Makrolon^{®} M2808 Massivplatte aus Beispiel 6 mit einem handelsüblichen Rakel (Sollschichtdicke (nass) 30 µm). Nach der Applikation schloss sich die Mikrowellenhärtung unter folgenden Bedingungen an:

Die Proben wurden in die Vakuumkammer eingeschleust und auf 4·10⁻⁴ mbar evakuiert. Danach wurde N₂-Gas bis zu einem Druck von 0,1 mbar eingelassen und ein Mikrowellen-Plasma mit einer Leistung von 1000 W für 1 min gezündet. Dies führte zur Aushärtung der Proben. Der Abstand zwischen Plasmaquelle und Substrat betrug jeweils zwischen 10 und 12 cm.

Die Schichtdicken der Beschichtungen wurden mit einem Weißlichtinterferrometer ETA-SST der Firma ETA-Optik GmbH ermittelt.

Der Yellowness-Index wurde gemäß ASTM D 313 mit einem Spektralphotometer Perkin Elmer Lambda 900 ermittelt.

Die Transmission bzw. Extinktion wurde analog in einem spektralen Bereich von 200 nm bis 700 nm von 0° / diffus nach ISO 13468-1 ermittelt.

Die Ergebnisse der Messungen der Beispiele 7 bis 11 sind in Tabelle 1 zusammengefasst.

| Beispiel | 7 | 8 | 9 | 10 | 11 |
|---|---|---|---|---|---|
| Beschichtungslösung aus Beispiel | 1 | 2 | 3 | 4 | 5 |
| Aussehen | trübe | klar | klar | Klar | Klar |
| Schichtdicke | 8 - 10 µm | 8 - 10 µm | 8 - 10 µm | 8 - 10 µm | 8 - 10 µm |
| Transmission | - | 88,8 | 89,2 | 88,8 | 89,9 |
| Optische Dichte @ 340nm | | 0,39 | 1,23 | 0,39 | 1,38 |
| Yellowness-Index | - | 4,7 | 3,1 | 4,2 | 2,7 |

### Beispiel 12

Die Beschichtungslösung aus Beispiel 5 wurde bei Normaldruck auf die Massivplatte aus Beispiel 6 innerhalb der Vakuumkammer aufgesprüht. Zum Versprühen wurde ein für Vakuumanwendungen optimierter Spritzautomat ½L von EFBE (Friedrich Boldt GmbH, Laatzen, Deutschland; www.efbe-technik.de) verwendet. Dazu wurde der Spritzautomat so umgebaut, dass er vakuumdicht war. Die Beschichtungslösung wurde dann mit Hilfe von Stickstoff-Gas mit einem Fluss von 0,5 l/min durch eine Düse (Durchmesser 300 µm) innerhalb von 5 s aufgesprüht. Der Abstand zwischen Spritzautomat und Substrat betrug 30 cm. Anschließend wurde die Probe auf 4·10⁻⁴ mbar evakuiert. Danach wurde N₂-Gas bis zu einem Druck von 0,1 mbar eingelassen und ein Mikrowellen-Plasma mit einer Leistung von 1000 W für 1 min gezündet. Dies führte zur Aushärtung der Proben.

### Beispiel 13

Die Massivplatte aus Beispiel 6 wurde in eine Vakuumkammer eingebracht, die Vakuumkammer evakuiert und die Beschichtungslösung aus Beispiel 2 mit Stickstoff bei einem Fluss von 0,4 l/min durch eine Düse (Durchmesser 300 µm) innerhalb von 10 s auf die Massivplatte gesprüht. Zum Versprühen wurde der Spritzenautomat aus Bsp. 12 verwendet. Dabei stellte sich ein Druck von 0,05 bis 0,1 mbar in der Vakuumkammer ein. Im Anschluss an den Sprühvorgang wurde die Vakuumkammer weiter auf 7·10⁻⁵ mbar evakuiert. Danach wurde wieder N₂-Gas bis zu einem Druck von 0,1 mbar eingelassen und ein Mikrowellen-Plasma mit einer Leistung von 1000 W für 1 min gezündet. Dies führte zur Aushärtung der Proben. Die Ergebnisse der Messungen der Beispiele 12 und 13 sind in Tabelle 2 zusammengefasst.

**Tabelle 2**

| Beispiel | 12 | 13 |
|---|---|---|
| Aussehen | klar transparente sowie leicht trübe Oberflächensegmente | trübe Oberflächesegmente |
| Schichtdicke | n.b. | n.b. |
| Transmission | 89,97 | 89,12 |
| Optische Dichte @ 340nm | 0,40 | 0,49 |
| Yellowness-Index | 1,59 | 2,46 |

| | | |
|---|---|---|
| n.b. - nicht bestimmt | | |

## Patentansprüche

1. Verfahren zur Beschichtung eines Kunststoffsubstrats mit Funktionsschichten, **dadurch gekennzeichnet, dass** man
(a) mindestens eine Oberfläche des Kunststoffsubstrats mit einer Funktionsschicht in Form eines Nasslacks in einer Vakuumkammer beschichtet und
(b) den Nasslack durch Einwirkung eines Plasmas in der Vakuumkammer bei Niederdruckbedingungen härtet.

2. Verfahren zur Beschichtung eines Kunststoffsubstrats mit Funktionsschichten, **dadurch gekennzeichnet, dass** man
(a) in einer Vakuumkammer bei Niederdruckbedingungen mittels plasmainduzierter Gasphasenabscheidung auf mindestens eine Oberfläche des Kunststoffsubstrats eine erste Funktionsschicht aufbringt,
(b) die beschichtete Oberfläche des Kunststoffsubstrats in der Kammer mit einer zweiten Funktionsschicht in Form eines Nasslacks beschichtet,
(c) den Nasslack durch Einwirkung eines Plasmas in der Vakuumkammer bei Niederdruckbedingungen härtet.

3. Verfahren nach Anspruch 1 oder 2, **dadurch gekennzeichnet, dass** man in der Vakuumkammer bei Niederdruckbedingungen mittels plasmainduzierter Gasphasenabscheidung auf die Nasslackschicht eine weitere Funktionsschicht aufbringt.

4. Verfahren nach einem der Ansprüche 1 bis 3, **dadurch gekennzeichnet, dass** der Auftrag des Nasslacks unter Niederdruckbedingungen stattfindet.

5. Verfahren nach einem der Ansprüche 1 bis 4, **dadurch gekennzeichnet, dass** die in Form eines Nasslacks aufgebrachte Funktionsschicht mindestens einen UV-Absorber enthält, insbesondere einen UV-Absorber unabhängig ausgewählt aus Triazinen, Biphenyltriazinen, Benztriazolen und Resorcinen.

6. Verfahren nach einem der Ansprüche 1 bis 5, **dadurch gekennzeichnet, dass** mindestens eine der durch Gasphasenabscheidung aufgebrachten Funktionsschichten eine Kratzfestigkeit verleihende Schicht ist und insbesondere aus einem oder mehreren der Precursoren Hexamethyldisiloxan, Octamethylcyclotetrasiloxan, Tetramethylcyclotetrasiloxane, Tetraethoxysilan, Tetramethyldisiloxan, Trimethoxymethylsilan, Dimethyldimethoxysilan, Hexamethyldisilazan, Triethoxyphenylsiloxan oder Vinylsilan besteht.

7. Verfahren nach einem der Ansprüche 1 bis 6, **dadurch gekennzeichnet, dass** das Kunststoffsubstrat ein thermoplastisch verarbeitbares Material ist, insbesondere Polycarbonat, Co-Polycarbonat, Polyestercarbonat, PET oder PETG sowie Poly- oder Copolyacrylate und Polyoder Copolymethacrylat wie Poly- oder Copolymethylmethacrylate als auch Mischungen vorgenannter Polymere.

8. Verfahren nach einem der Ansprüche 4 bis 7, **dadurch gekennzeichnet, dass** der Druck in der Vakuumkammer während des Auftrags des Nasslacks kleiner oder gleich 100 mbar ist, vorzugsweise kleiner oder gleich 10 mbar, insbesondere im Bereich von 10⁻² mbar bis 5 mbar.

9. Verfahren nach einem der Ansprüche 1 bis 8, **dadurch gekennzeichnet, dass** der Druck in der Vakuumkammer bei der Aushärtung mittels Plasma im Bereich von 10⁻⁵ mbar bis 100 mbar, vorzugsweise im Bereich 10⁻³ mbar bis 10 mbar, insbesondere im Bereich von 10⁻² mbar bis 1 mbar.

10. Verfahren nach einem der Ansprüche 1 bis 9, **dadurch gekennzeichnet, dass** das Aufbringen des Nasslacks durch Sprühen erfolgt, insbesondere durch Sprühen mit einem Inertgas.

11. Verfahren nach Anspruch 10, **dadurch gekennzeichnet, dass** die Sprühdauer so gewählt wird, das die Nasslackschicht eine bei 340 nm Wellenlänge gemessene optische Dichte von größer oder gleich 0,4 aufweist.

12. Verfahren nach einem der Ansprüche 1 bis 11, **dadurch gekennzeichnet, dass** das zum Aushärten des Nasslacks eingesetzte Plasma ein Mikrowellenplasma ist.

13. Verfahren nach einem der Ansprüche 1 bis 12, **dadurch gekennzeichnet, dass** das Plasma zum Härten des Nasslacks für eine Dauer im Bereich von 1 Sekunden bis 10 Minuten gezündet wird, besonders bevorzugt im Bereich von 2 Sekunden bis 5 Minuten, insbesondere im Bereich von 3 Sekunden bis 2 Minuten.

14. Verfahren nach einem der Ansprüche 1 bis 13, **dadurch gekennzeichnet, dass** Plasmagas zum Härten des Nasslacks ausgewählt ist aus Stickstoff, Helium oder einer Mischung aus beidem.

15. Beschichtetes Kunststoffsubstrat, **dadurch gekennzeichnet, dass** es mindestens eine UV-Schutzbeschichtung und gegebenenfalls eine Kratzschutzbeschichtung aufweist und durch ein Verfahren nach einem der Ansprüche 5 bis 14 hergestellt wurde.

16. Verwendung des beschichteten Kunststoffsubstrats mit mindestens einer UV-Schutzbeschichtung und gegebenenfalls mindestens einer Kratzschutzbeschichtung zur Herstellung von Gehäusen für Elektrogeräte, Fensterprofilen, Scheinwerferstreuscheiben, Karosserieelementen, Maschinenabdeckungen, Autoscheiben und Architekturverscheibungen.

17. Vorrichtung zur Beschichtung eines Kunststoffsubstrats mit Funktionsschichten, umfassend eine Vakuumkammer, mindestens eine Sprühvorrichtung und mindestens eine Plasmaquelle, wobei die Sprühvorrichtung und die Plasmaquelle innerhalb der Vakuumkammer angeordnet sind.
